(19) 

Europäisches
Patentamt
European
Patent Office
Office européen
des brevets

(11) **EP 3 232 236 A1**

(12) **EUROPEAN PATENT APPLICATION**
published in accordance with Art. 153(4) EPC

(43) Date of publication:
**18.10.2017 Bulletin 2017/42**

(21) Application number: **15866693.3**

(22) Date of filing: **27.11.2015**

(51) Int Cl.:
*G01V 8/12* (2006.01)    *B60H 1/00* (2006.01)
*B60R 16/02* (2006.01)    *G01J 1/02* (2006.01)
*H01L 35/32* (2006.01)

(86) International application number:
**PCT/JP2015/005898**

(87) International publication number:
**WO 2016/092760 (16.06.2016 Gazette 2016/24)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **08.12.2014 JP 2014247613**
　　　　　　**19.03.2015 JP 2015055655**
　　　　　　**16.04.2015 JP 2015084048**

(71) Applicant: **Panasonic Intellectual Property
Management Co., Ltd.
Osaka-shi, Osaka 540-6207 (JP)**

(72) Inventors:
• **KAKIMOTO, Katsumi
Osaka-shi
Osaka 540-6207 (JP)**
• **YAMANAKA, Hiroshi
Osaka-shi
Osaka 540-6207 (JP)**

• **SUGIYAMA, Takanori
Osaka-shi
Osaka 540-6207 (JP)**
• **HATTORI, Isao
Osaka-shi
Osaka 540-6207 (JP)**
• **HIGUCHI, Yuichi
Osaka-shi
Osaka 540-6207 (JP)**
• **ARAI, Hideyuki
Osaka-shi
Osaka 540-6207 (JP)**
• **HAGIHARA, Yosuke
Osaka-shi
Osaka 540-6207 (JP)**

(74) Representative: **Grünecker Patent- und
Rechtsanwälte
PartG mbB
Leopoldstraße 4
80802 München (DE)**

(54) **DETECTION DEVICE AND VEHICLE CONTROL DEVICE USING SAME**

(57) A detection device is used with a vehicle including a cabin, a ceiling, pillars, a driver seat, and a passenger seat. The detection device includes a detector disposed on the ceiling or the pillars of the vehicle and detecting an object in the cabin while not contacting the object, and a scanning unit that moves the detector for scan. The detection device can detect a temperature of the object accurately, and control air-conditioning comfortably to the object.

FIG. 8

**EP 3 232 236 A1**

**Description**

TECHNICAL FIELD

The present invention relates to a detector for detecting an object while not contacting the object, and a vehicle control device including the detector in a cabin.

BACKGROUND ART

A detector using an infrared camera can detect an object while not contacting the object.
FIG. 33 is a top view of conventional detector 201 disclosed in PTL 1. Detector 201 includes operating part 207, camera 212, and an image processor. Operating part 207 is located to be operable by driver 205 sitting on driver seat 203 near vehicle lateral center line 202 and grabbing steering wheel 204 and by passenger 209 sitting on passenger's seat 206. Camera 212 is disposed to allow left hand 208 of driver 205 and right hand 210 of passenger 209 to reach operating part 207 from driver seat 203 and passenger seat 206, respectively, to be within a capturing range and to enable capturing in predetermined range 211 from operating part 207 to the front of seats. The image processor processes image data obtained by camera 212, and determines whether an operator based on a determination result on the operator whose hand reaches operating part 207 is driver 205 or passenger 209.
The detector detects an occupant while not contacting the occupant. The vehicle is air-conditioned based on a detection result of the detector.
FIG. 34 illustrates conventional vehicle control device 1 disclosed in PTL 2. In vehicle control device 1, two first infrared sensors are disposed in sensor casing 2. The infrared sensors are illustrated as individual sensitive surfaces 3 and 4. Sensitive surface 3 detects range 5 including a driver seat, and sensitive surface 4 detects range 6 including a passenger seat.
To accurately determine a temperature distribution within a range including a passenger on a rear seat, sensor casing 7 including the second infrared sensor is disposed in a controller in a ceiling or the rear of a vehicle. The second infrared sensor includes two beam sensors constituted by first and second beam sensors. The first beam sensor serving as sensitive surface 8 detects a range behind the driver seat toward a rear window, and the second beam sensor serving as sensitive surface 9 detects a range between the passenger seat and the rear window.
PTL 3 discloses a conventional infrared sensor including a beam having plural bent portions to have a relatively large length. PTL 4 and PTL 5 disclose conventional infrared sensors similar to the above sensors.

CITATION LIST

PATENT LITERATURES

PTL 1: Japanese Patent Laid-Open Publication No. 2004-67031
PTL 2: Japanese Patent Laid-Open Publication No. 2000-94923
PTL 3: Japanese Patent Laid-Open Publication No. 2006-170937
PTL 4: Japanese Patent Laid-Open Publication No. 2009-288066
PTL 5: Japanese Patent Laid-Open Publication No. 2010-048803

SUMMARY

A detection device is configured to be used with a vehicle including a cabin, a ceiling, plural pillars, a driver seat, and a passenger seat. The detection device includes a detector disposed on the ceiling or the pillars of the vehicle and a scanning unit that moves the detector for scan. The detector is configured to detect an object in the cabin while not contacting the object
The detection device can detect a temperature of the object accurately, and can control air-conditioning comfortably to the object.

BRIEF DESCRIPTION OF DRAWINGS

FIG. 1 is a schematic view of a detection device according to Exemplary Embodiment 1.

FIG. 2 is a front view of the detection device according to Embodiment 1.

FIG. 3A illustrates a detection principle of the detection device according to Embodiment 1.

FIG. 3B is an enlarged view of a detector of the detection device according to Embodiment 1.

FIG. 3C is an enlarged view of another detector of the detection device according to Embodiment 1.

FIG. 4 is a schematic view of a vehicle control device according to Embodiment 1.

FIG. 5A is a top view of a vehicle having a vehicle control device according to Embodiment 1 installed thereto.

FIG. 5B illustrates an interior of the vehicle illustrated in FIG. 5A.

FIG. 6 is a front view of the vehicle control device according to Embodiment 1.

FIG. 7 illustrates occupants operating an electronic device according to Embodiment 1.

FIG. 8 is a block diagram of a vehicle control device according to Exemplary Embodiment 2.

FIG. 9 is a front view of a detection device to be used in the vehicle control device according to Embodiment 2.

FIG. 10A is a top view of a vehicle having the detection device according to Embodiment 2 installed thereto.

FIG. 10B is a partially enlarged view of an interior of the vehicle illustrated in FIG. 10A.

FIG. 11 is a side view of the vehicle according to Embodiment 2.

FIG. 12 illustrates a scanning part of the vehicle control device according to Embodiment 2.

FIG. 13 illustrates a detectable range of the detection device according to Embodiment 2.

FIG. 14 illustrates a dashboard according to Embodiment 2.

FIG. 15 is a block diagram of a vehicle control device according to Exemplary Embodiment 3.

FIG. 16 is a front view of a detection device of the vehicle control device according to Embodiment 3.

FIG. 17 is a top view of the detection device according to Embodiment 3.

FIG. 18 is a block diagram of a vehicle control device according to Exemplary Embodiment 4.

FIG. 19 is a front view of a detection device of the vehicle control device according to Embodiment 4.

FIG. 20 is a top view of the detection device according to Embodiment 4.

FIG. 21 is a block diagram of a vehicle control device according to Exemplary Embodiment 5.

FIG. 22 is a front view of a detection device of the vehicle control device according to Embodiment 5.

FIG. 23 is a top view of the detection device according to Embodiment 5.

FIG. 24 is a block diagram of a vehicle control device according to Exemplary Embodiment 6.

FIG. 25 is a front view of a detection device according to Embodiment 6.

FIG. 26 is a top view of the detection device according to Embodiment 6.

FIG. 27 is a schematic view of an infrared sensor according to Exemplary Embodiment 7.

FIG. 28A is a top view of an infrared detection unit of the infrared sensor according to Embodiment 7.

FIG. 28B is a cross-sectional view of the infrared detection unit along line 28B-28B illustrated in FIG. 28A.

FIG. 28C is a cross-sectional view of the infrared detection unit along line 28C-28C illustrated in FIG. 28A.

FIG. 29A is a top view of an infrared detection unit of an infrared sensor according to Exemplary Embodiment 8.

FIG. 29B is a cross-sectional view of the infrared detection unit along line 29B-29B illustrated in FIG. 29A.

FIG. 29C is a cross-sectional view of the infrared detection unit illustrated in FIG. 29A taken along line 29C-29C.

FIG. 30A is a top view of an infrared detection unit of an infrared sensor according to Exemplary Embodiment 9.

FIG. 30B is a cross-sectional view of the infrared detection unit along 30B-30B illustrated in FIG. 30A.

FIG. 30C is a cross-sectional view of the infrared detection unit along 30C-30C illustrated in FIG. 30A.

FIG. 31A is a top view of an infrared detection unit of an infrared sensor according to Exemplary Embodiment 10.

FIG. 31B is a cross-sectional view of the infrared detection unit along line 31B-31B illustrated in FIG. 31A.

FIG. 31C is a cross-sectional view of the infrared detection unit along line 31C-31C illustrated in FIG. 31A.

FIG. 32A is a top view of an infrared detection unit of an infrared sensor according to Exemplary Embodiment 11.

FIG. 32B is a cross-sectional view of the infrared detection unit along line 32B-32B illustrated in FIG. 32A.

FIG. 32C is a cross-sectional view of the infrared detection unit along line 32C-32C illustrated in FIG. 31A.

FIG. 32D is a cross-sectional view of the infrared detection unit along line 32D-32D illustrated in FIG. 32A.

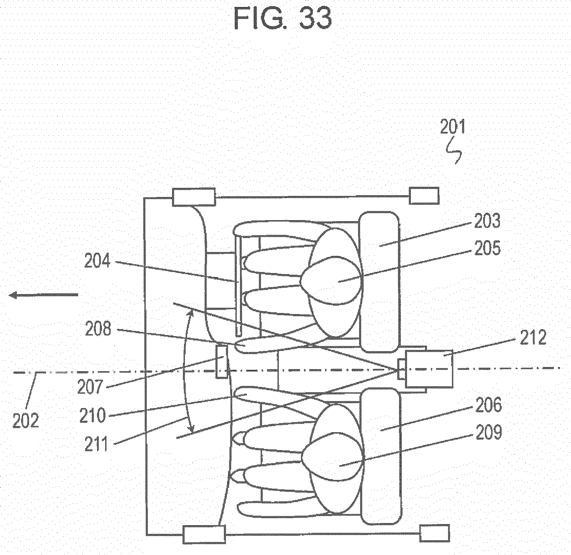

FIG. 33 is a top view of a conventional detector.

FIG. 34 illustrates a conventional vehicle control device.

DETAIL DESCRIPTION OF PREFERRED EMBODIMENTS

Exemplary Embodiment 1

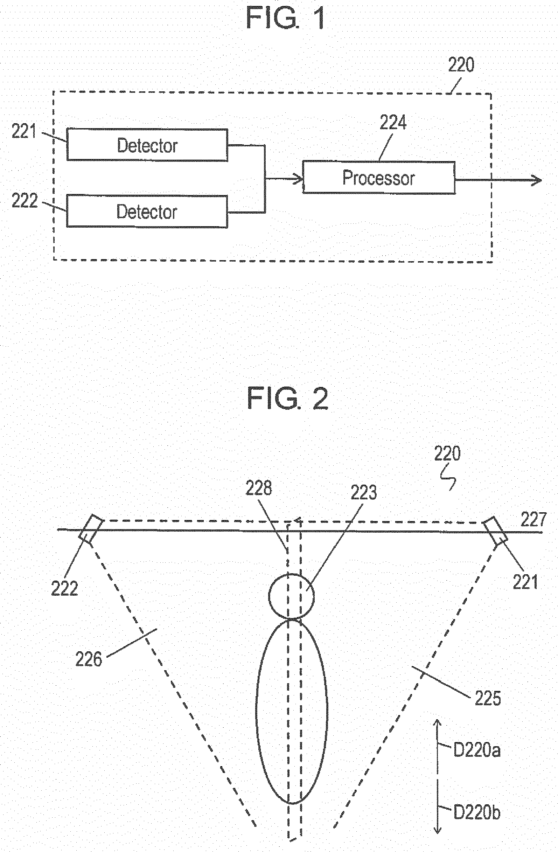

FIG. 1 is a schematic diagram of detection device 220 according to Exemplary Embodiment 1. FIG. 2 is a front view of detection device 220.

Detection device 220 includes detector 221, detector 222, and processor 224. Processor 224 processes outputs from detector 221 and detector 222, and measures object 223, such as a human, an article, such as a beverage or an electronic device, or a pet, irradiating infrared rays.

Detection device 220 is disposed above a space, such as a cabin or a house, where object 223 moves so that a range where object 223 that is an occupant to be measured by detection device 220 moves coincides with a detectable range of detector 221 and a detectable range of detector 222. That is, detector 221 and detector 222 are installed such that object 223 moves between detector 221 and detector 222 and below detector 221 and detector 222. In the following description, a side where detector 221 and detector 222 are disposed shown in FIG. 2 will be referred to as "above" and a side where object 223 is disposed will be referred to as "below." Detectors 221 and 222 are disposed in upward direction D220a, and object 223 is disposed in downward direction D220b.

Detectors 221 and 222 face downward to a direction between detector 221 and detector 222 such that object 223 is located in each of detectable range 225 of detector 221 and detectable range 226 of detector 222. Processor 224 processes outputs of detector 221 and detector 222 disposed as described above to determine which one of detector 221 or detector 222 is closer to object 223 and to measure a location of object 223 projected on plane 228 having a normal line which is line 227 connecting detector 221 to detector 222 perpendicularly to plane 228. Line 227 is perpendicular to upward direction D220a and downward direction D220b. That is, plane 228 is parallel to upward direction D220a and downward direction D220b.

Detector 221 and detector 222 according to Embodiment 1 are implemented by infrared sensors and can detect object 223 while not contacting the object. Each of the infrared sensors includes a thermal infrared detection unit having a temperature sensing unit embedded therein. The temperature sensing unit is a thermoelectric converter implemented by a thermopile for converting thermal energy caused by infrared rays from object 223 to electrical energy. The infrared sensor has plural pixel units each including the temperature sensing unit and a MOS transistor for extracting an output voltage of the temperature sensing unit. The number of pixel units is $a \times b$, and the pixel units are arranged in a one-dimensional array or a two-dimensional array with a rows and b columns on a surface of a semiconductor substrate. The pixel units are implemented by non-contact infrared detection elements. The number of pixel units satisfies $a \geq 1$ and $b \geq 1$. $8 \times 8$ of the pixel units are arranged according to Embodiment 1. While advantages of Embodiment 1 can be obtained by using cameras or TOF sensors as detectors 221 and 222, the infrared sensors can provide highly accurate detection device 220 inexpensively.

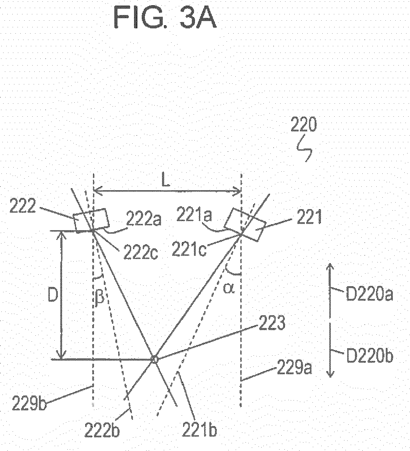

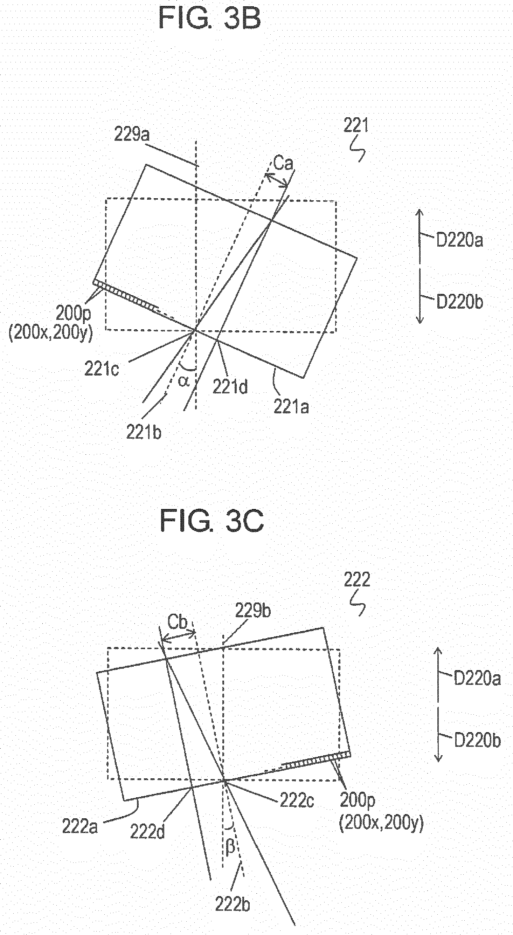

The detection of object 223 by detection device 220 will be described below. FIG. 3A illustrates a detecting operation of detection device 220. FIG. 3B is an enlarged view of detector 221. FIG. 3C is an enlarged view of detector 222. In FIGS. 3B and 3C, detectors 221 and 222 that are not tilted are indicated by broken lines.

Tilting of detectors 221 and 222 will be described below. Detectors 221 and 222 are infrared sensors 200x having including light-receiving surfaces 221a and 222a for receiving infrared rays, respectively. Pixel units 200p described above and each constituted by non-contact infrared detecting element 200y are arranged along light-receiving surfaces 221a and 222a. Each of detectors 221 and 222 has a detectable range where infrared rays can be detected. These detectable ranges pass through middles 221c and 222c of light-receiving surfaces 221a and 222a, and expand from center axes 221b and 222b extending perpendicularly to light-receiving surfaces 221a and 222a, respectively. Thus, detectors 221 and 222 have directivities from center axes 221b and 222b, respectively.

Distance D from one of middle 221c of detector 221 and middle 222c of detector 222 to object 223 in a corresponding one of the directions of axes 229a and 229b is expressed by formula (1) with a distance L between middle 221c of detector 221 and middle 222c of detector 222, a tilt angle $\alpha$ of center axis 221b of detector 221 from axis 229a on plane 228 and extending in upward direction D220a (downward direction D220b), a tilt angle $\beta$ of center axis 222b of detector 222 from axis 229b on plane 228 and extending in upward direction D220a (downward direction D220b), a focal length f of detectors 221 and 222, a distance Ca from middle 221c of light-receiving surface 221a of detector 221 to thermal centroid 221d of object 223, and a distance Cb from middle 222c of light-receiving surface 222a of detector 222 to thermal centroid 222d of object 223.

$$D = \frac{L \cdot f}{Ca \cdot \cos\alpha + f \cdot \sin\alpha + Cb \cdot \cos\beta + f \cdot \sin\beta} \quad \cdots (1)$$

Formula (1) provides distance D from detection device 220 to object 223 so that a position of object 223 projected perpendicularly onto plane 228 can be calculated.

Detectors 221 and 222 allows detection device 220 not only to detect which one of detector 221 or 222 is closer to object 223 but also to detect the position of object 223 projected perpendicularly onto plane 228. Formula (1) allows object 223 to be accurately detected with a simple algorithm.

Vehicle control device 230 using detection device 220 will be described below.

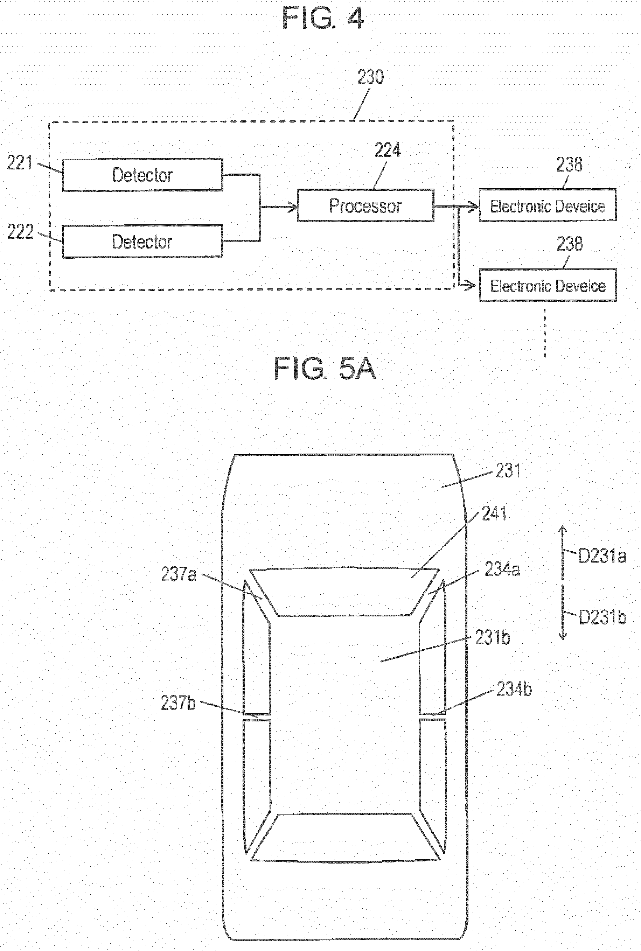

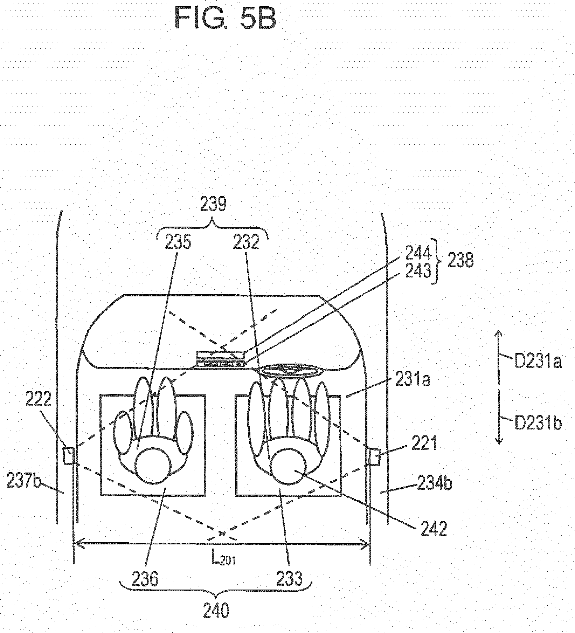

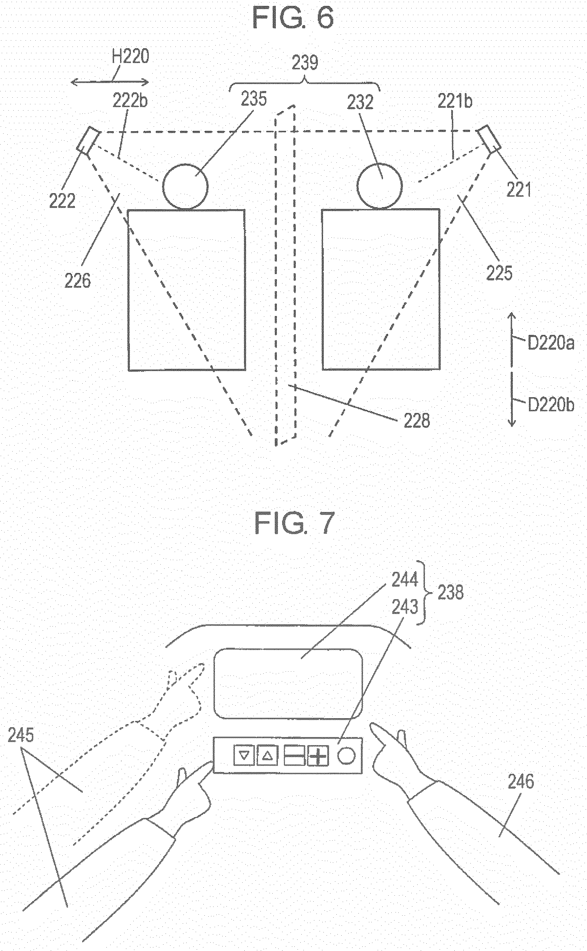

FIG. 4 is a schematic diagram of vehicle control device 230. FIG.5A is a top view of vehicle 231. FIG. 5B illustrates an inside of vehicle 231. FIG. 6 is a front view of vehicle control device 230. Vehicle 231 includes cabin 231a, ceiling 231b, pillars 234a, 234b, 237a, and 237b, driver seat 233, and passenger seat 236. Detector 221 is closer to driver seat 233 than to passenger seat 236, whereas detector 222 is disposed closer to passenger seat 236 than to driver seat 233.

In vehicle control device 230 according to Embodiment 1, detector 221 is provided on B-pillar 234b closer to driver seat 233 to have driver 232 of vehicle 231 seated thereon, and detector 222 is disposed on another B-pillar 237b closer to passenger seat 236 to have passenger 235 seated thereon. Detector 221 and detector 222 are connected to processor 224. Processor 224 processes outputs of detector 221 and detector 222, and controls electronic device 238. Center axis 221b of detector 221 and center axis 222b of detector 222 are disposed in downward direction D220b with respect to horizontal direction H220 and face seats 240 (driver seat 233 and passenger seat 236) to have occupants 239 (driver 232 and passenger 235), which are objects 223, to be seated thereon. Middle 221c of detector 221 is located away from middle 222c of detector 222 by a distance of 1500 mm. Middles 221c and 222c are disposed at a middle of seats 240 in forward direction D231a (rearward direction D231b) perpendicular to upward direction D220a (downward direction D220b) of vehicle 231. Detectors 221 and 222 are disposed such that center axis 221b of detector 221 and center axis 222b of detector 222 are tilted toward windshield 241 of vehicle 231 with respect to line 227 connecting middle 221c of detector 221 to middle 222c of detector 222.

Detector 221 and detector 222 disposed at a middle of seats 240 in forward direction D231a (rearward direction D231b) prevents head 242 of occupant 239 from entering a detectable range of a closer one of detector 221 or detector 222, and facilitates the whole body of occupant 239 to enter a detectable range of the other of detector 221 or detector 222 away from the occupant. This allows occupants 239 to be detected accurately by vehicle control device 230. In addition, since detectors 221 and 222 are disposed on B-pillars 234b and 237b, respectively, detectors 221 and 222 are less likely to be seen by occupant 239 when occupant 239 is seated on seat 240 so that detectors 221 and 222 may not hinder driving. Thus, it is possible to detect an operation of occupant 239 accurately without impairing comfort of occupant 239. Detectors 221 and 222 are preferably disposed at a middle of seats 240 in forward direction D231a (rearward direction D231b) of B-pillars 234b and 237b. Alternatively, detectors 221 and 222 may be disposed closer to windshield 241 than to the middle. In this case, it is possible to prevent head 242 of one of occupants 239 seated closer to detectors 221 and 222 from hindering. That is, it is possible to prevent errors in detection caused in a situation where occupant 239 is seated near detector 221 or detector 222 and the detectable range of detector 221 is occupied by head 242 of driver 232 or the detectable range of detector 222 is occupied by head 242 of occupant 239 on passenger seat 236.

Since detector 221 and detector 222 are disposed such that center axes 221b and 222b are tilted in downward direction D220b toward seats 240 with respect to horizontal direction H220, detector 221 or detector 222 can detect the whole body of occupant 239, thereby detecting occupant 239 accurately.

Distance L between middle 221c of detector 221 and middle 222c of detector 222 is 1500 mm, distance L may be changed as necessary depending on vehicle 231 having vehicle control device 230 mounted thereto. In particular, distance L preferably ranges from 500 mm to 1500 mm. In this case, vehicle control device 230 can be applied to typical automobiles.

Since center axes 221b and 222b of detectors 221 and 222 are tilted toward windshield 241 of vehicle 231 with respect to line 227, a cause of an erroneous detection in which occupant 239 closer to detector 221 and detector 222 is incorrectly detected as occupant 239 farther from detector 221 and detector 222 can be reduced, and thus, occupant 239 can be accurately detected.

Control of electronic device 238 by vehicle control device 230 will be described below.

FIG. 7 illustrates occupant 239 operating electronic device 238. In accordance with Embodiment 1, electronic device 238 controlled by vehicle control device 230 is an air conditioner and a car navigation system. Operation panel 244 of the car navigation system is disposed above switch 243 of the air conditioner. Control of electronic device 238 by vehicle control device 230 in this state will be described. Table 1 shows control of electronic device 238 by vehicle control device 230.

[Table 1]

| Object 223 | Switch 243 | Operation Panel 244 |
|---|---|---|
| Passenger 235 | Light | Start/Screen Display |
| Driver 232 | Turn Off | Turn off |

In the case where passenger 235 has hand 245 extend from passenger seat 236 to switch 243 of the air conditioner as to have hand 245 of passenger 235 approach switch 243 of the air conditioner, processor 224 determines, based on detection results of detector 221 and detector 222, that passenger 235 tries to operate the air conditioner. At this moment, processor 224 causes switch 243 of the air conditioner to illuminate, and performs control of facilitating operation of switch 243 of the air conditioner.

In a case where passenger 235 on passenger seat 236 has hand 245 extend to operation panel 244 of the car navigation system, the processor 224 detects that hand 245 is close to operation panel 244 above switch 243 of the air conditioner and controls display on operation panel 244 for easy operation by passenger 235, such as starting up operation panel 244 or showing a necessary display, such as a search screen on operation panel 244.

On the other hand, in a case where driver 232 has hand 246 extend from driver seat 233 to switch 243 of the air conditioner or operation panel 244 of the car navigation system, processor 224 determines that driver 232 tries to operate the air conditioner or the car navigation system from driver seat 233. At this moment, if vehicle 231 runs, operation from driver seat 233 is dangerous. Thus, to avoid danger, switch 243 or operation panel 244 is turned off in order to prevent operation by driver 232.

Vehicle control device 230 can thus detect a movement of object 223 in a direction parallel to plane 228, and can determine that electronic device 238 out of electronic devices 238 occupant 239 tries to operate, and performs control for each operation, thereby enhancing comfort of occupant 239. In addition, it is possible to determine which one of detectors 221 and 222 is closer to object 223, and thus, electronic device 238 can be controlled to avoid danger of vehicle 231 due to operation by driver 232 during running of vehicle 231. Accordingly, safety of vehicle 231 can be enhanced.

The control method for electronic device 238 is not limited to the method described above. Electronic device 238 may be controlled to enhance comfort of occupant 239 by other methods such as a method of ejecting a disc when occupant 239 extends a hand to a place near the disc in a music player, for example.

Although detector 221 and detector 222 are disposed on B-pillars 234b and 237b, detectors 221 and 222 may be disposed on not B-pillars 234b and 237b but A-pillars 234a and 237a. In this case, detectors 221 and 222 are also less likely to be seen by occupant 239 so that detectors 221 and 222 can detect an operation of occupant 239 without discomfort of occupant 239.

With typical detector 201 disclosed in PTL 1, in a vehicle equipped with a plurality electronic devices in a vertical direction, a driver and a passenger cannot be distinguished with respect to electronic devices except an operating part.

On the other hand, vehicle control device 230 according to the first exemplary embodiment can determine movements not only in lateral directions of object 340 but also upward direction D220a and downward direction D220b to control electronic device 238, and thus, is useful especially for controlling an air conditioner and other devices of vehicle 231 and houses.

Detector 221 is disposed closer to driver seat 233 than to passenger seat 236. Detector 222 is disposed closer to passenger seat 236 than to driver seat 233. Detection device 220 includes processor 224 that detects, based on outputs of detectors 221 and 222, a movement of occupant 239 on plane 228 having normal line coincide with line 227 connecting detector 221 to detector 222.

Each of detector 221 and detector 222 is implemented by infrared sensor 200x including plural infrared detecting elements 200y arranged in a one-dimensional array or a two-dimensional array.

Processor 224 may detect distance D from the occupant to each of detectors 221 and 222 in a direction perpendicular to a line connecting detector 221 to detector 222 by Formula (1) with a distance L between detectors 221 and 222, a tilt angle $\alpha$ of detector 221, a tilt angle $\beta$ of detector 222, a focal length f of detectors 221 and 222, a distance Ca from center 221a of light-receiving surface 221a of detector 221 to thermal centroid 221d of the occupant, and a distance Cb from middle 222c of a light-receiving surface of detector 222 to thermal centroid 222d of the occupant.

$$D = \frac{L \cdot f}{Ca \cdot \cos\alpha + f \cdot \sin\alpha + Cb \cdot \cos\beta + f \cdot \sin\beta} \quad \cdots (1)$$

Vehicle control device 230 is mounted to vehicle 231 having electronic device 238 mounted thereto. Vehicle control device 230 includes detection device 220 and processor 224 that controls an electronic device based on outputs of detectors 221 and 222. Detectors 221 and 222 are disposed in cabin 231a of vehicle 231.

Detectors 221 and 222 may be tilted toward windshield 241 of vehicle 231 with respect to line 227 connecting detector 221 to detector 222.

Detectors 221 and 222 may be disposed on A-pillars 234a and 237a or B-pillars 234b and 237b of vehicle 231.

Detector 221 may be disposed such that, when an occupant is closer to detector 222, the whole body of the occupant is within detectable range 225 of detector 221, and detector 222 may be disposed such that when an occupant is closer to detector 221, the whole body of the occupant is within detectable range 226 of detector 222.

The distance between detectors 221 and 222 may be equal to or larger than 500 mm and is equal to or smaller than 1500 mm.

Processor 224 may determine, based on outputs of detector 221 and detector 222, which side of detector 221 or detector 222 an occupant is seated.

Upon detecting that an occupant approaches one of electronic devices 238, processor 224 may control this electronic device without controlling the other electronic devices.

Exemplary Embodiment 2

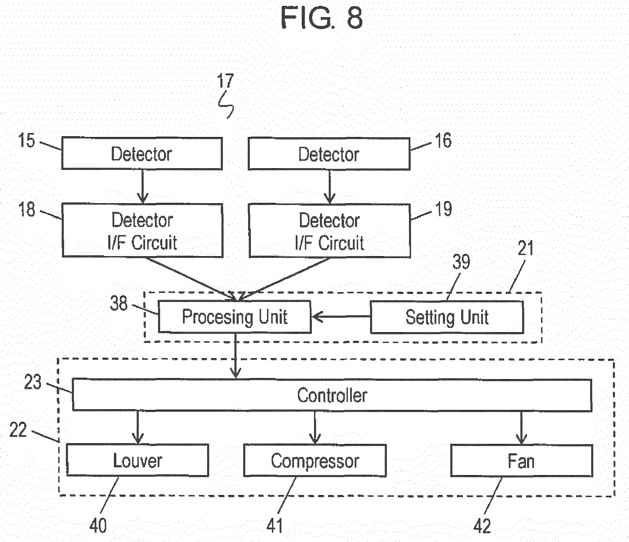

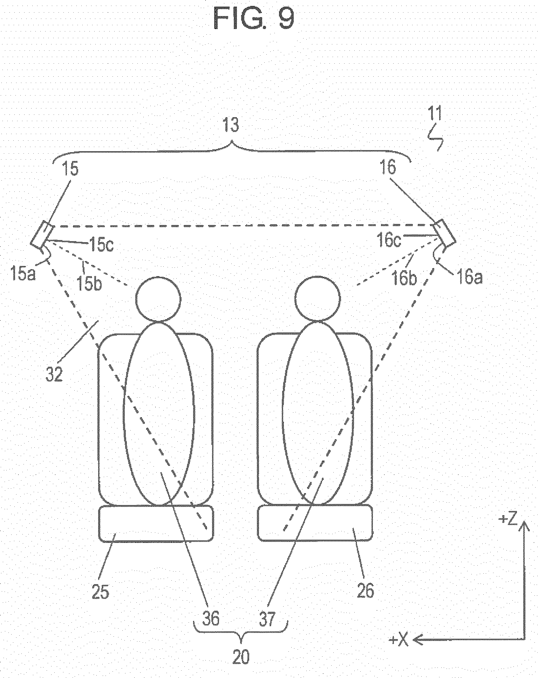

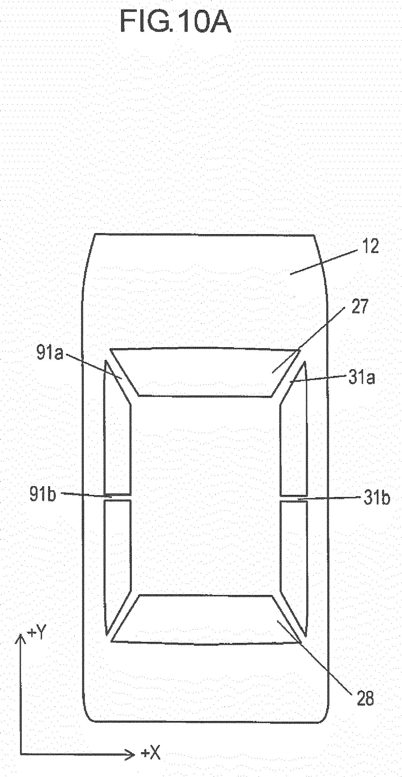

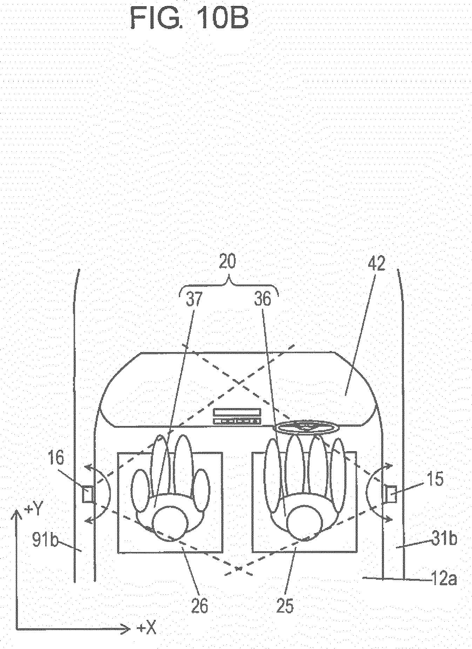

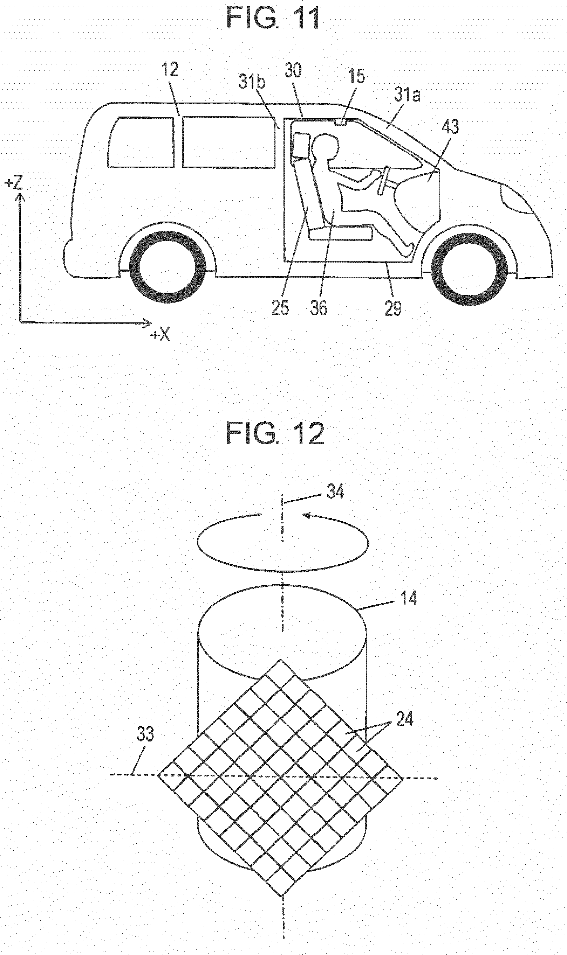

FIG. 8 is a block diagram of vehicle control device 17 according to Exemplary Embodiment 2. FIG. 9 is a front view of detection device 11 for use in vehicle control device 17. FIG. 10A is a top view of vehicle 12 on which detection device 11 is mounted. FIG. 10B is an enlarged view of an interior of vehicle 12. FIG. 11 is a side view of vehicle 12.

Detection device 11 according to Embodiment 2 includes detector 13 mounted to vehicle 12 and scanning part 14 that moves detector 13 for scan. Detector 13 includes detector 15 and detector 16. Vehicle control device 17 includes detection device 11, detector interface (I/F) circuit 18 connected to detector 15, and detector I/F circuit 19 connected to detector 16. Vehicle control device 17 further includes processor 21 and controller 23. Processor 21 estimates thermal feeling of occupant 20 that is an object irradiating infrared rays, such as a human, an object such as a beverage or an electronic device, or a pet, based on outputs of detector I/F circuit 18 and detector I/F circuit 19. Controller 23 controls air conditioner 22 based on an estimated result of the thermal feeling. The thermal feeling of occupant 20 herein refers to the degree of hot or cold felt by occupant 20.

Each of detector 15 and detector 16 is implemented by plural infrared sensors. Each of the infrared sensors includes a thermal infrared detection unit in which a temperature sensing unit is embedded. The temperature sensing unit is a thermoelectric converter constituted by a thermopile for converting thermal energy caused by infrared rays from an object to electrical energy. In the infrared sensor, $a \times b$ pixel units 24 each including the temperature sensing unit and a MOS transistor for extracting outputs of the temperature sensing unit are arranged in a two-dimensional array of a rows and b columns on a surface of a semiconductor substrate. Pixel units 24 are implemented by non-contact infrared detection elements. In accordance with Embodiment 2, pixel units 24 are arranged in a matrix that is an array of eight rows and eight columns. Infrared sensors for detector 15 and detector 16 can provide highly accurate temperature sensors inexpensively.

An arrangement of detection device 11 in vehicle 12 will be described below. Vehicle 12 includes cabin 12a, ceiling 30, pillars 31a, 31b, 91a, and 91b, driver seat 25, and passenger seat 26. In the following description, directions connecting driver seat 25 and passenger seat 26 are defined as X-axis directions. In particular, a direction from passenger seat 26 toward driver seat 25 is defined as a positive direction of the X-axis, and a direction from driver seat 25 toward passenger seat 26 is defined as a negative direction of the X-axis. Directions connecting windshield 27 and rear windshield 28 are defined as Y-axis directions. In particular, a direction from rear windshield 28 toward windshield 27 is defined as a positive direction of the Y-axis, and a direction from windshield 27 toward rear windshield 28 is defined as a negative direction of the Y-axis. Directions connecting floor 29 and ceiling 30 will be hereinafter referred to as Z-axis directions. In particular, a direction from floor 29 toward ceiling 30 is defined as a positive direction of the Z-axis, and a direction from ceiling 30 to floor 29 is defined as a negative direction of the Z-axis. The X-axis, Y-axis, and Z-axis are perpendicular to one another.

Detector 15 is disposed on B-pillar 31b closer to driver seat 25 and detector 16 is disposed on B-pillar 91b closer to passenger seat 26 in vehicle 12. Detector 15 is disposed closer to driver seat 25 than to passenger seat 26, and detector 16 is disposed closer to passenger seat 26 than to driver seat 25. Detector 15 and detector 16 are disposed such that occupant 20 enters in detectable ranges 32 of detector 15 and detector 16. Detector 15 and detector 16 are disposed at a middle of seats (driver seat 25 and passenger seat 26) in the Y-axis directions. Since detector 15 and detector 16 are disposed on B-pillars 31b and 91b, detectors 15 and 16 are less likely visible from occupant 20 so that detectors 15 and 16 can detect occupant 20 without hindering comfort of occupant 20. Although detector 15 and detector 16 may be disposed not on B-pillars 31b and 91b but on A-pillar 31a and 91a, detector 15 and detector 16 are preferably disposed on B-pillars 31b and 91b. This is because the whole body of occupant 20 can be easily detected in this case. Although detector 15 and detector 16 are disposed at a middle of the seats in the Y-axis directions, the present invention is not limited to this example. The positions of detectors 15 and 16 may be changed depending on the configuration of vehicle 12.

Tilting of detectors 15 and 16 will be specifically described. As illustrated in FIG. 9, detectors 15 and 16 include light-receiving surfaces 15a and 16a for detecting infrared rays, respectively. Each of detectors 15 and 16 has a detectable range where each detector can detect infrared rays. Pixel units 24 implemented by non-contact infrared detecting elements are arranged along light-receiving surfaces 15a and 16a. The detectable ranges of detectors 15 and 16 pass through middles 15c and 16c of light-receiving surfaces 15a and 16a and expand from center axes 15b and 16b perpendicular to light-receiving surfaces 15a and 16a, respectively. Thus, detectors 15 and 16 have directivity flaring about center axes 15b and 16b, respectively.

Detectors 15 and 16 are disposed such that center axis 15b of detector 15 and center axis 16b of detector 16 are tilted by 60 degrees in the negative direction of the Z-axis of vehicle 12 with respect to a line connecting middle 15c of detector 15 and middle 16c of detector 16. This arrangement enables detection of temperatures of fingertips and knees of occupant 20, and thus, the whole body of occupant 20 can be easily detected. Although center axis 15b of detector 15 and center axis 16b of detector 16 are tilted by 60 degrees in the negative direction of the Z-axis, this tilt angle may be changed as appropriate depending on the configuration of vehicle 12. In this manner, in detection device 11 according to Embodiment 2, the angles of detector 15 and detector 16 can be changed depending on the configuration of vehicle 12. Thus, detection device 11 is applicable to a wide variety of vehicles 12.

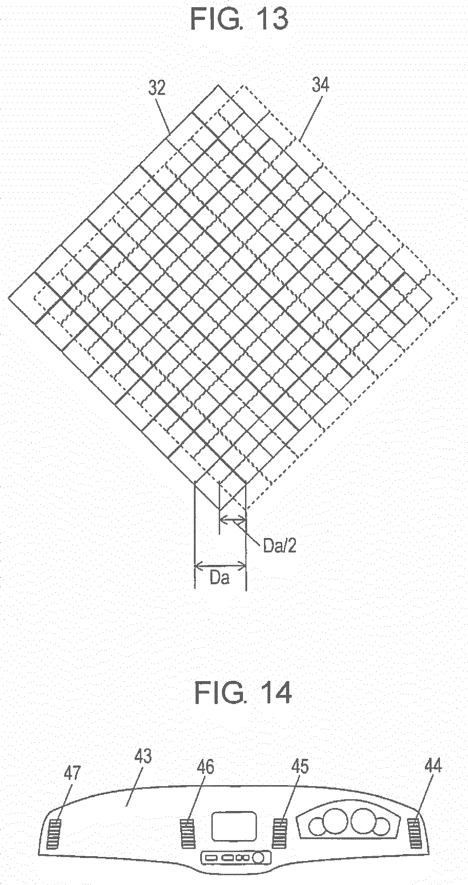

Scan of detectable ranges of detector 15 and detector 16 will be described below, using detector 15 as an example. FIG. 12 illustrates scan of a detectable range of detector 15 by scanning part 14. FIG. 13 illustrates detectable ranges 32 and 34 of detector 15 to be scanned. In FIG. 13, detectable range 34 of detector 15 obtained by scanning pixel units 24 in a length of 1/2 of length D1, that is, a length of Da/2, of pixel units 24 of detector 15 along long axis 33 (a longest portion of pixel units 24) is denoted by broken lines. Length Da is merely an example for description, and the invention is not limited to this length. Length Da may be determined as appropriate depending on application conditions of detection device 11.

Scanning part 14 includes a device, such as a motor, for rotating detector 15 (16), rotates detector 15 about rotation axis 35 in a direction of long axis 33 of pixel units 24 by distance Da at each predetermined time, and performs scan by a predetermined distance.

Detector 15 detects infrared rays at each scan, and after the scan, obtains a temperature distribution by summing up temperature distributions obtained by detector I/F circuit 18. By summing up temperature distributions, a resolution of the resulting temperature distribution is increased. Detector 15 after completion of scan is moved reversely for scan, detects infrared rays by distance Da at each scan similarly, and after the scan in the reverse direction, acquires a temperature distribution with a high resolution.

In this manner, by obtaining a temperature distribution with a high resolution, temperature of occupant 20 can be separated from temperatures of background such as a seat so that the temperature of occupant 20 can be accurately measured. In addition, by obtaining a temperature distribution with a high resolution, occupants 20, such as driver 36 and passenger 37, can be accurately distinguished from each other. This accurate distinction enhances detection accuracy of detector 15 and detector 16 and accuracy in estimating thermal feeling so that air-conditioning can be optimally controlled. Since air-conditioning can be optimally controlled, fuel efficiency of vehicle 12 can be increased, and comfort of occupant 20 can be enhanced.

Processor 21 includes processing unit 38 and setting unit 39. Processing unit 38 estimates thermal feeling based on the temperature distribution obtained by detector 15 and detector 16. Setting unit 39 has a threshold for use in estimation of thermal feeling.

Air conditioner 22 includes controller 23 that controls air conditioner 22, louver 40, compressor 41, and fan 42. Louver 40, compressor 41, and fan 42 are connected to controller 23. Controller 23 controls louver 40, compressor 41, and fan 42 depending on an output of processing unit 38, thereby controlling air-conditioning.

An operation of processing unit 38 for estimating thermal feeling will be described below.

First, processing unit 38 acquires a temperature distribution from outputs of detector 15 and detector 16.

Next, processing unit 38 distinguishes a temperature of occupant 20 from background temperature of, for example, a seat, based on the temperature distribution obtained from detector 15 and detector 16. Processing unit 38 calculates an average temperature of occupant 20 (hereinafter described as a temperature of occupant 20), and estimates thermal feeling of occupant 20 from the temperature of occupant 20 and background temperatures. The thermal feeling has steps, such as "hot," "very hot," "cold," "very cold," and "moderate", determined in accordance with the degree of thermal feeling of occupant 20

Air conditioner 22 is controlled according to an estimation result of thermal feeling. For example, in a case where thermal feeling of occupant 20 is estimated to be at a stage at which occupant 20 feels "hot," processing unit 38 controls air conditioner 22 to reduce a set temperature of a cooler or increase the amount of air. After controlling air conditioner 22 according to the estimated temperature feeling, processing unit 38 continuously estimates thermal feeling for a predetermined time. After the predetermined time elapses, if the thermal feeling of occupant 20 is not at the stage of "moderate," processing unit 38 controls air conditioner 22 according to the estimated thermal feeling at this moment. In this manner, thermal feeling is estimated, and air conditioner 22 is performed after a lapse of the predetermined time in accordance with the thermal feeling so that air conditioner 22 can be frequently controlled, thereby preventing occupant 20 from feeling uncomfortably.

FIG. 14 illustrates dashboard 43 of vehicle 12 according to Embodiment 2.

Detection device 11 according to Embodiment 2 includes detector 15 disposed closer to driver seat 25, detector 16 disposed closer to passenger seat 26, detector I/F circuit 18, detector I/F circuit 19, scanning part 14 that moves detector 15 and detector 16 for scan, processor 21, and controller 23.

Detector 15 and detector 16 are tilted by 60 degrees in the negative direction of the Z-axis of vehicle 12 with respect to a line connecting middle 15c of detector 15 and middle 16c of detector 16. Detector 15 and detector 16 are moved for scan in the Y-axis directions. That is, center axis 15b of detector 15 and center axis 16b of detector 16 rotate on a plane including the Y-axis.

Dashboard 43 of vehicle 12 includes air outlet 44, air outlet 45, air outlet 46, and air outlet 47 arranged in this order from driver seat 25 to passenger seat 26.

Detection device 11 according to Embodiment 2 distinguishes driver 36 and passenger 37 from each other based on outputs of detector 15 and detector 16, and estimates thermal feeling of driver 36 and passenger 37. In accordance with the estimated thermal feeling, air conditioner 22 is controlled differently between driver 36 and passenger 37. More specifically, air supply from air outlet 44 and air outlet 45 closer to driver 36 is controlled in accordance with the thermal feeling of driver 36, whereas air supply from air outlet 46 and air outlet 47 closer to passenger seat 26 is controlled in accordance with the thermal feeling of passenger 37. In this manner, occupant 20 is distinguished so that air-conditioning is controlled in accordance with thermal feeling of each occupant 20, thereby allowing occupants 20 to be comfortable.

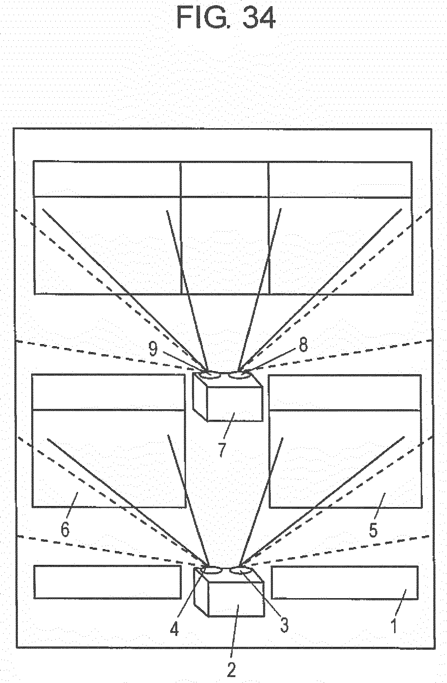

In typical vehicle control device 1 illustrated in FIG. 34, the whole body of an occupant cannot be detected, resulting in difficulty in controlling air-conditioning for providing comfort of each occupant.

In vehicle 12 including detection device 11 according to Embodiment, air supply from air outlet 44 may be controlled differently from air supply from air outlet 45 with air supply from air outlet 46 being controlled differently from air supply from air outlet 47. In this manner, air outlets closer to the same occupant 20 may be individually controlled so that comfort of occupant 20 can be further enhanced.

Exemplary Embodiment 3

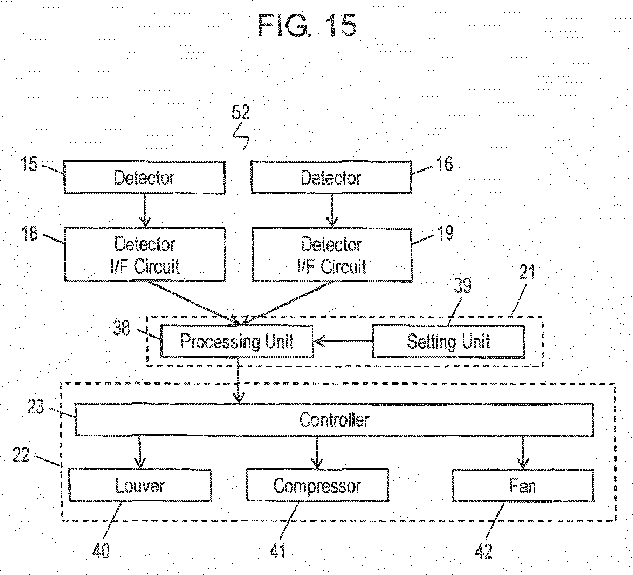

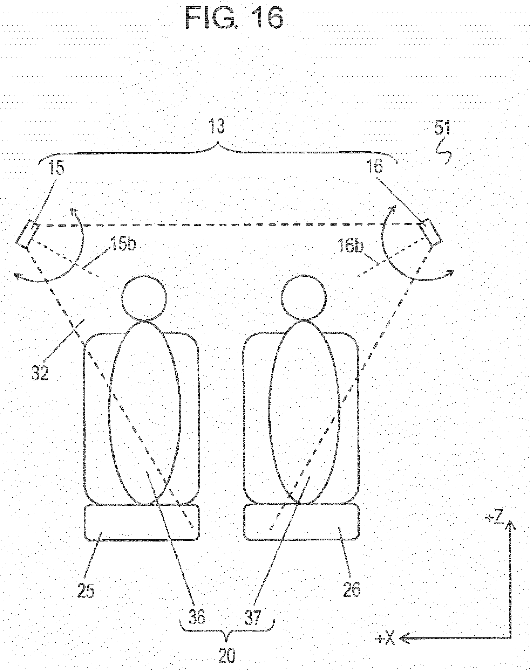

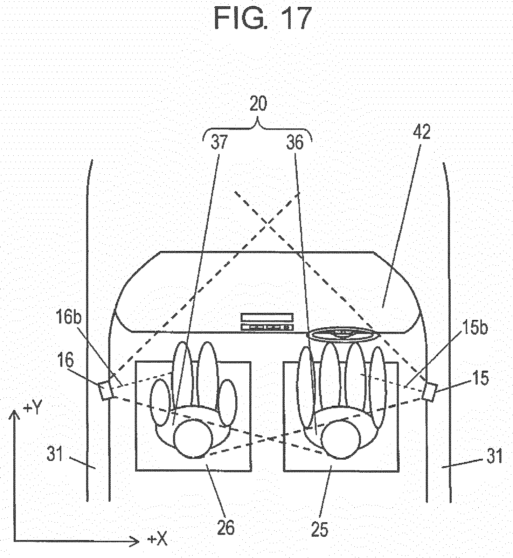

FIG. 15 is a block diagram of vehicle control device 52 according to Exemplary Embodiment 3. FIG. 16 is a front view of detection device 51 of vehicle control device 52. FIG. 17 is a top view of detection device 51. In FIGS. 15 to 17, components identical to those of vehicle control device 17 and detection device 11 according to Embodiment 2 illustrated in FIGS. 8 and 9 are denoted by the same reference numerals. Detection device 51 according to Embodiment 3 is different from detection device 11 according to Embodiment 2 in arrangement and scan of detectable ranges of detector 13 (detector 15 and detector 16).

Detection device 51 according to Embodiment 3 includes detector 13 mounted on vehicle 12. Detector 13 includes detector 15 and detector 16. Vehicle control device 52 further includes detection device 51, detector I/F circuit 18 connected to detector 15, and detector I/F circuit 19 connected to detector 16. Detector 15 and detector 16 are connected to scanning part 14. Vehicle control device 52 further includes processor 21 and controller 23. Processor 21 estimates thermal feeling of occupant 20 from outputs of detector I/F circuit 18 and detector I/F circuit 19. Controller 23 controls air conditioner 22 based on the estimated thermal feeling.

Detector 15 is disposed on B-pillar 31b closer to driver seat 25 of vehicle 12, and detector 16 is disposed on B-pillar 91b closer to passenger seat 26. Since detector 15 and detector 16 are disposed on B-pillars 31b and 91b, detectors 15 and 16 are less likely visible from occupant 20 so that detectors 15 and 16 can detect occupant 20 without discomfort of occupant 20.

Detectors 15 and 16 are disposed such that center axis 15b of detector 15 and center axis 16b of detector 16 are tilted by an angle ranging from 10 to 15 degrees in a positive direction of the Y-axis. This arrangement can prevent a failure in detecting occupant 20 away from detector 15 and detector 16 due to hindering by a head of occupant 20 closer to detector 15 and detector 16. In this manner, accuracy in distinguishing driver 36 and passenger 37 can be further enhanced. Detector 15 and detector 16 are moved for scan in Z-axis directions by scanning part 14. That is, center axis 15b of detector 15 and center axis 16b of detector 16 rotate in a plane including a Z-axis. Thermal feeling of occupant 20 is estimated from outputs of detector 15 and detector 16. Air conditioner 22 is controlled in accordance with the estimated thermal feeling. In this manner, air conditioner 22 can be controlled to provide comfort of occupant 20. Detector 15 and detector 16 are tilted by an angle ranging from 10 to 15 degrees in the positive direction of the Y-axis. However, the invention is not limited to this example, and the tilt angle may be changed as appropriate depending on the configuration of vehicle 12. In this manner, the angle of detector 15 and detector 16 can be changed depending on the configuration of vehicle 12 so that detection device 51 is applicable to a wide variety of vehicles 12.

Detection device 51 can detect temperatures of fingertips and knees of occupant 20 in detail. In this manner, detection accuracy of detector 15 and detector 16 is enhanced so that estimation accuracy of thermal feeling can be enhanced. This enables optimum control of air-conditioning so that fuel efficiency of vehicle 12 can be enhanced and comfort of occupant 20 can also be enhanced.

Since detection device 51 can measure a precise temperature distribution of occupant 20, thermal feeling of each occupant 20 can be estimated for driver 36 and passenger 37. The estimated thermal feeling of each occupant 20 may be used for controlling air conditioner 22 for each occupant 20. Such control can enhance comfort of occupant 20.

Exemplary Embodiment 4

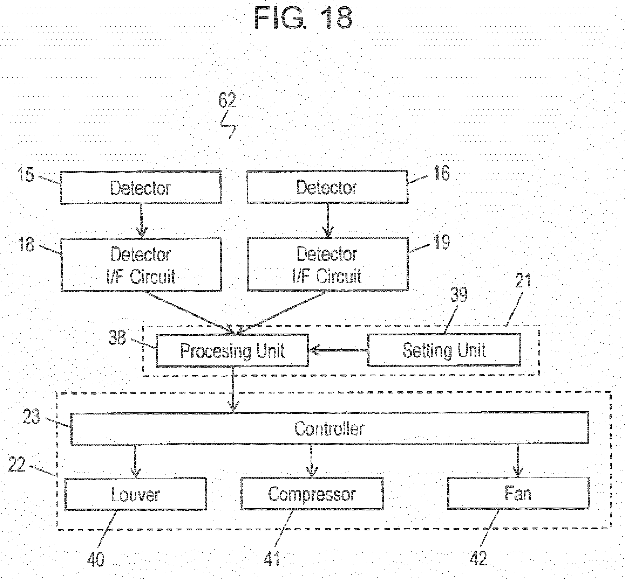

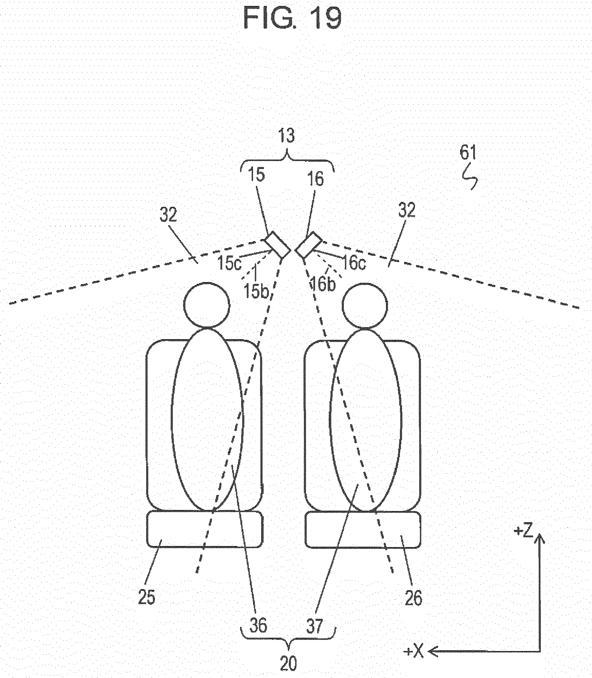

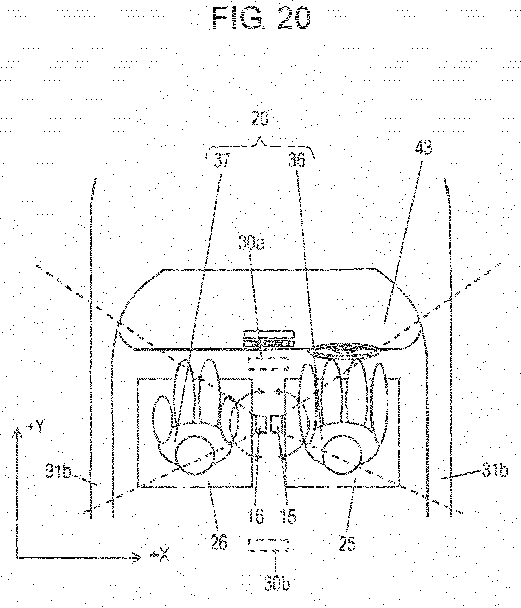

FIG. 18 is a block diagram of vehicle control device 62 according to Exemplary Embodiment 4. FIG. 19 is a front view of detection device 61 of vehicle control device 62. FIG. 20 is a top view of detection device 61. In FIGS. 18 to 20, components identical to those of vehicle control device 17 and detection device 11 according to Embodiment 2 illustrated in FIGS. 8 and 9 are denoted by the same reference numerals. Detection device 61 according to Embodiment 4 is different from detection device 11 according to Embodiment 2 in arrangement and scan of detection detector 13 (detector 15 and detector 16).

Detection device 61 according to Embodiment 4 includes detector 13 mounted on vehicle 12. Detector 13 includes detector 15 and detector 16. Vehicle control device 62 includes detection device 61, detector I/F circuit 18 connected to detector 15, and detector I/F circuit 19 connected to detector 16. Detector 15 and detector 16 are connected to scanning part 14. Vehicle control device 62 further includes processor 21 and controller 23. Processor 21 estimates thermal feeling of occupant 20 from outputs of detector I/F circuit 18 and detector I/F circuit 19. Controller 23 controls air conditioner 22 based on the estimated thermal feeling.

Viewing downward from ceiling 30 of vehicle 12, detector 15 and detector 16 are disposed between driver seat 25 and passenger seat 26 and near a middle between inside rearview mirror 30a and room lamp 30b. Light-receiving surface 15a of detector 15 faces driver seat 25, and light-receiving surface 16a of detector 16 faces passenger seat 26. Since detector 15 and detector 16 are disposed on ceiling 30, detectors 15 and 16 are less likely visible from occupant 20 so that detectors 15 and 16 can detect occupant 20 without discomfort of occupant 20.

Center axis 15b of detector 15 and center axis 16b of detector 16 are tilted by 45 degrees in a negative direction of the Z-axis with respect to a line connecting middle 15c of detector 15 and middle 16c of detector 16. Detector 15 and detector 16 are moved for scan by scanning part 14 in Y-axis directions. That is, center axis 15b of detector 15 and center axis 16b of detector 16 rotate in a plane including a Y-axis. Processor 21 estimates thermal feeling of occupant 20 from outputs of detector 15 and detector 16. Controller 23 controls air conditioner 22 in accordance with the estimated thermal feeling. In this manner, air conditioner 22 can be controlled to provide comfort of occupant 20. Center axis 15b of detector 15 and center axis 16b of detector 16 are tilted by 45 degrees in the negative direction of the Z-axis. However, the invention is not limited to this example, and this tilt angle may be changed as necessary depending on the configuration of vehicle 12.

In detection device 61, detector 15 and detector 16 are moved for scan in the Y-axis directions so that temperatures of fingertips and knees of occupant 20 can be detected precisely. In this manner, detection accuracy of detector 15 and detector 16 is enhanced so that estimation accuracy of thermal feeling can be enhanced. This enables optimum control of air-conditioning so that fuel efficiency of vehicle 12 can be enhanced and comfort of occupant 20 can also be enhanced. Viewing from above, detection device 61 is disposed between driver seat 25 and passenger seat 26 and near a center between inside rearview mirror 30a and room lamp 30b. Thus, the installation angle of detection device 61 does not depend on the type of the vehicle so that detection device 61 is applicable to a wide variety of vehicles 12.

Since detection device 61 can detect a precise temperature distribution of occupant 20, thermal feeling of each occupant 20, each of driver 36 and passenger 37, can be estimated. The estimated thermal feeling of each occupant 20 may be used for controlling air conditioner 22 for each occupant 20. Such control can enhance comfort of occupant 20.

Exemplary Embodiment 5

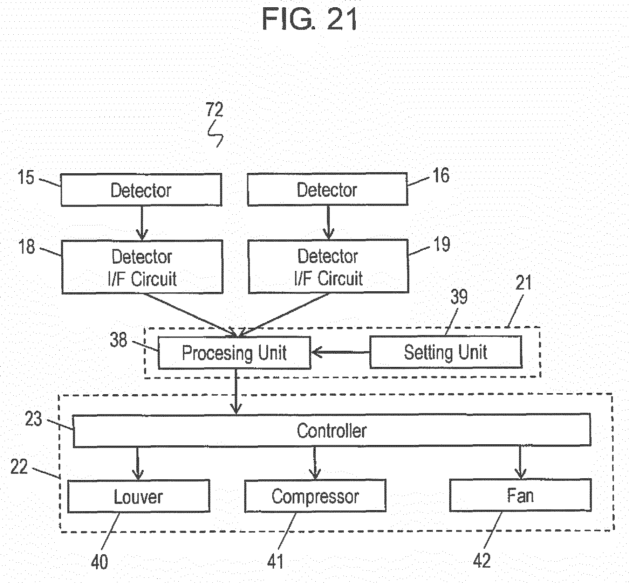

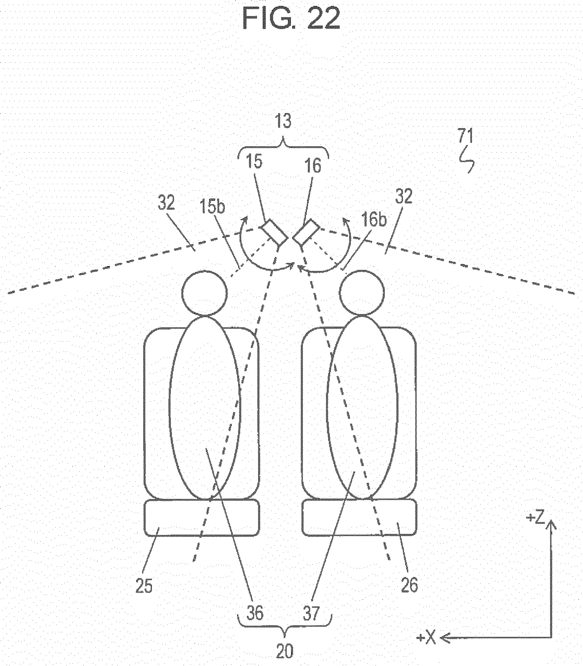

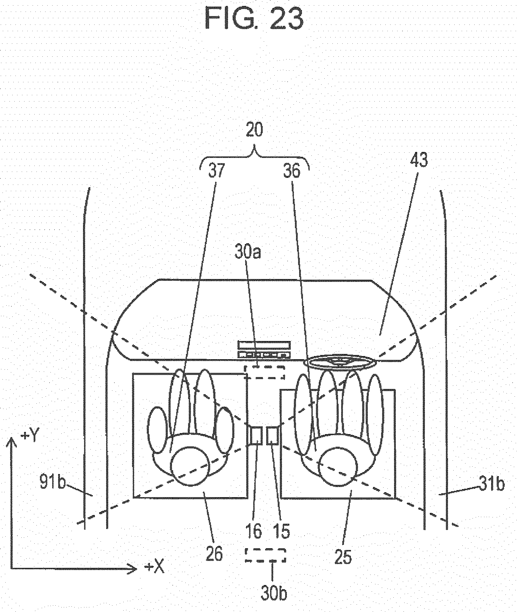

FIG. 21 is a block diagram of vehicle control device 72 according to Exemplary Embodiment 5. FIG. 22 is a front view of detection device 71 of vehicle control device 72. FIG. 23 is a top view of detection device 71. In FIGS. 21 to 23, components identical to those of vehicle control device 17 and detection device 11 according to Embodiment 2 illustrated in FIGS. 8 and 9 are denoted by the same reference numerals. Detection device 71 according to Embodiment 5 is different from detection device 11 according to Embodiment 2 in arrangement and scan of detectable ranges of detector 13 (detector 15 and detector 16).

Detection device 71 according to Embodiment 5 includes detector 13 mounted on vehicle 12. Detector 13 includes detector 15 and detector 16. Vehicle control device 72 includes detection device 71, detector I/F circuit 18 connected to detector 15, and detector I/F circuit 19 connected to detector 16. Detector 15 and detector 16 are connected to scanning part 14. Vehicle control device 72 further includes processor 21 and controller 23. Processor 21 estimates thermal feeling of occupant 20 from outputs of detector I/F circuit 18 and detector I/F circuit 19. Controller 23 controls air conditioner 22 based on the estimated thermal feeling.

Viewing downward from ceiling 30 of vehicle 12, detector 15 and detector 16 are disposed between driver seat 25 and passenger seat 26 and near a middle between inside rearview mirror 30a and room lamp 30b. Light-receiving surface 15a of detector 15 faces driver seat 25, and light-receiving surface 16a of detector 16 faces passenger seat 26. Since detector 15 and detector 16 are disposed on ceiling 30, detectors 15 and 16 are less likely visible from occupant 20 so that detectors 15 and 16 can detect occupant 20 without discomfort of occupant 20.

Detector 15 and detector 16 are moved for scan in Z-axis directions by scanning part 14. That is, center axis 15b of detector 15 and center axis 16b of detector 16 rotate in a plane including a Z-axis. Processor 21 estimates thermal feeling of occupant 20 from outputs of detector 15 and detector 16 having detectable ranges scanned by scanning part 14. Controller 23 controls air conditioner 22 in accordance with the estimated thermal feeling. In this manner, air conditioner 22 can be controlled to provide comfort of occupant 20. In this manner, the angle of detector 15 and detector 16 can be changed depending on the configuration of vehicle 12 so that detection device 71 is applicable to a wide variety of vehicles 12.

Detection device 71 can detect temperatures of fingertips and knees of occupant 20 precisely. In this manner, detection accuracy of detector 15 and detector 16 is enhanced so that estimation accuracy of thermal feeling can be enhanced. This enables optimum control of air-conditioning so that fuel efficiency of vehicle 12 can be enhanced and comfort of occupant 20 can also be enhanced.

Since detection device 71 can detect a precise temperature distribution of occupant 20, thermal feeling of each occupant 20 can be estimated for driver 36 and passenger 37. The estimated thermal feeling of each occupant 20 may be used for controlling air conditioner 22 for each occupant 20. Such control can enhance comfort of occupant 20.

Detector 15 and detector 16 may be disposed on inside rearview mirror 30a or room lamp 30b. In the configuration where detectors 15 and 16 are disposed on inside rearview mirror 30a or room lamp 30b, detector 15 and detector 16 can detect the entire interior of vehicle 12.

Detector 15 and detector 16 may be disposed in front of driver seat 25 and passenger seat 26. In the configuration where detectors 15 and 16 are disposed in front of driver seat 25 and passenger seat 26, detectors 15 and 16 can detect a temperature of the face of occupant 20 at the front thereof to estimate thermal feeling more accurately.

Exemplary Embodiment 6

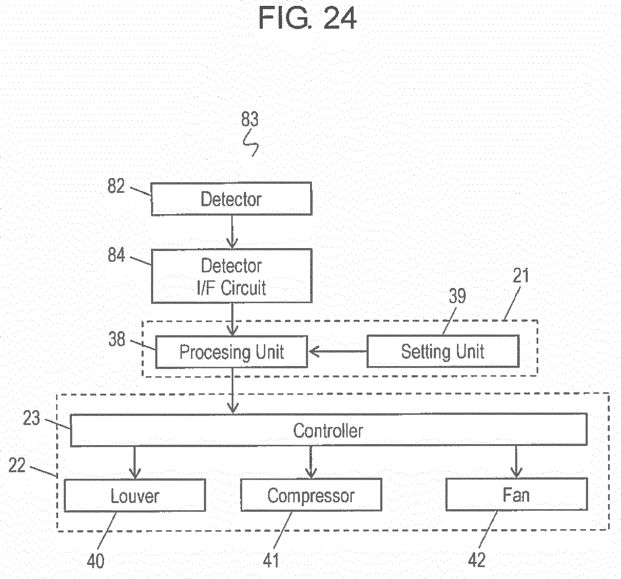

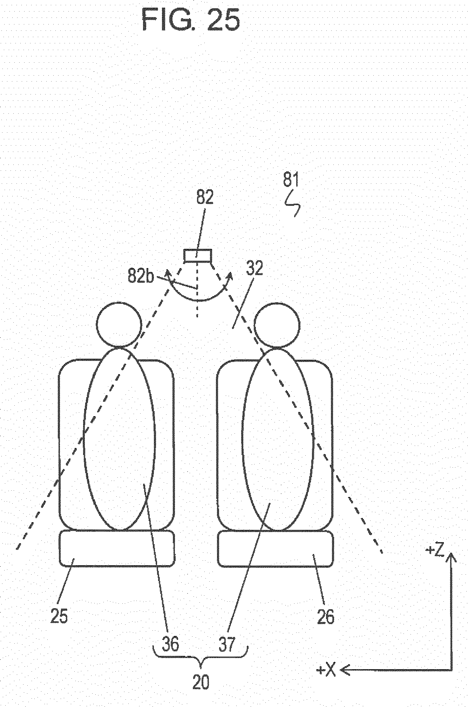

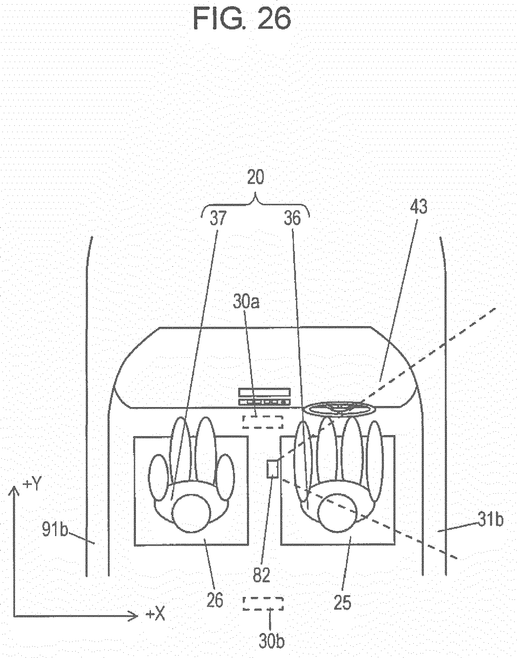

FIG. 24 is a block diagram of vehicle control device 83 according to Exemplary Embodiment 7. FIG. 25 is a front view of detection device 81 of vehicle control device 83. FIG. 26 is a top view of detection device 81. In FIGS. 24 to 26, components identical to those of vehicle control device 17 and detection device 11 according to Embodiment 2 illustrated in FIGS. 8 and 9 are denoted by the same reference numerals.

Detection device 81 according to Embodiment 6 includes detector 82 mounted on vehicle 12. Vehicle control device 83 includes detection device 81, detector I/F circuit 84 connected to detector 82, and scanning part 14 that moves detector 82 for scan. Vehicle control device 83 further includes processor 21 and controller 23. Processor 21 estimates thermal feeling of occupant 20 from an output of detector I/F circuit 84. Controller 23 controls air conditioner 22 based on the estimated thermal feeling.

Viewing downward from ceiling 30 of vehicle 12, detector 82 is disposed between driver seat 25 and passenger seat 26 and near a middle between inside rearview mirror 30a and room lamp 30b. Since detector 82 is disposed on ceiling 30, detector 82 is less likely visible from occupant 20 so that detector 82 can detect occupant 20 without discomfort of occupant 20.

Scanning part 14 moves detector 82 for scan such that center axis 82b of detector 82 moves from a horizontal direction toward driver seat 25 parallel to ceiling 30 to a direction toward driver seat 25, then to a direction toward floor 29, to a direction toward passenger seat 26, and then to a direction toward passenger seat 26 parallel to ceiling 30. From the state in which axis 82b is directed toward passenger seat 26 and is parallel to ceiling 30, detector 82 is moved for scan reversely until axis 82b is directed toward driver seat 25 and is parallel to ceiling 30. In this manner, center axis 82b of detector 82 is moved for scan along a line connecting driver seat 25 and passenger seat 26. Processor 21 estimates thermal feeling of occupant 20 from an output of detector 13 moved for scan by scanning part 14. Controller 23 controls air conditioner 22 in accordance with the estimated thermal feeling. In this manner, air conditioner 22 can be controlled to provide comfort to occupant 20.

By moving detector 82 for scan in X-axis directions, detection device 81 can detect temperatures of fingertips and knees of occupant 20 precisely. In this manner, detection accuracy of detector 82 is enhanced so that estimation accuracy of thermal feeling can be enhanced. Since air-conditioning can be optimally controlled, fuel efficiency of vehicle 12 can be increased, and comfort of occupant 20 can be enhanced.

In detection device 81, since one detector 82 can detect occupant 20 and estimate thermal feeling, vehicle control device 83 can be inexpensive.

In addition, since detection device 81 can measure a precise temperature distribution of occupant 20, thermal feeling of each occupant 20, each of driver 36 and passenger 37, can be estimated. The estimated thermal feeling of each occupant 20 may be used for controlling air conditioner 22 for each occupant 20. Such control can enhance comfort of occupant 20.

As described above, vehicle 12 includes cabin 12a, ceiling 30, pillars 31b and 91b (31a and 91a), driver seat 25, and passenger seat 26. Detection devices 11, 51, 61, 71, and 81 are used together with vehicle 12. Detection device 11 includes detector 13 that detects occupant 20 in cabin 12a while not contacting occupant 20 and scanning part 14 that moves detector 13 for scan. Detector 13 is disposed on ceiling 30 or pillar 31a (31b) of vehicle 12.

Detector 13 may include detector 15 disposed closer to driver seat 25 than to passenger seat 26 and detector 16 disposed closer to passenger seat 26 than driver seat 25.

In this case, the pillars include B-pillars 31b and 91b. Detector 15 and detector 16 are disposed on B-pillars 31b and 91b.

Vehicle 12 further includes windshield 27 facing cabin 12a and rear windshield 28 facing cabin 12a. Scanning part 14 may move detector 15 and detector 16 for scan in a direction toward windshield 27 to a direction toward rear windshield 28.

Detector 15 and detector 16 may be tilted toward windshield 27 with respect to a line connecting detector 15 to detector 16.

Vehicle 12 further includes floor 29 facing cabin 12a. Scanning part 14 may move detector 15 and detector 16 for scan from a direction toward floor 29 to a direction toward ceiling 30.

Viewing from ceiling 30, detector 15 and detector 16 may be disposed between driver seat 25 and passenger seat 26.

Scanning part 14 may move detector 15 and detector 16 for scan from a direction toward floor 29 to a direction toward ceiling 30.

Scanning part 14 may move detector 13 for scan along a line connecting driver seat 25 to passenger seat 26.

Vehicle control device 17 (52, 62, 72, 83) includes detection device 11 (51, 61, 71, 81) and controller 23. Controller 23 is configured to estimate thermal feeling of occupant 20 based on an output of detection device 11 (51, 61, 71, 81), and to control air conditioner 22 mounted on the vehicle in accordance with the estimated thermal feeling.

Air conditioner 22 may be disposed close to driver seat 25. In this case, controller 23 may be configured to estimate thermal feeling of an occupant on a passenger seat and to control air conditioner 22 close to passenger seat 26 of vehicle 12 in accordance with the estimated thermal feeling.


Exemplary Embodiment 7


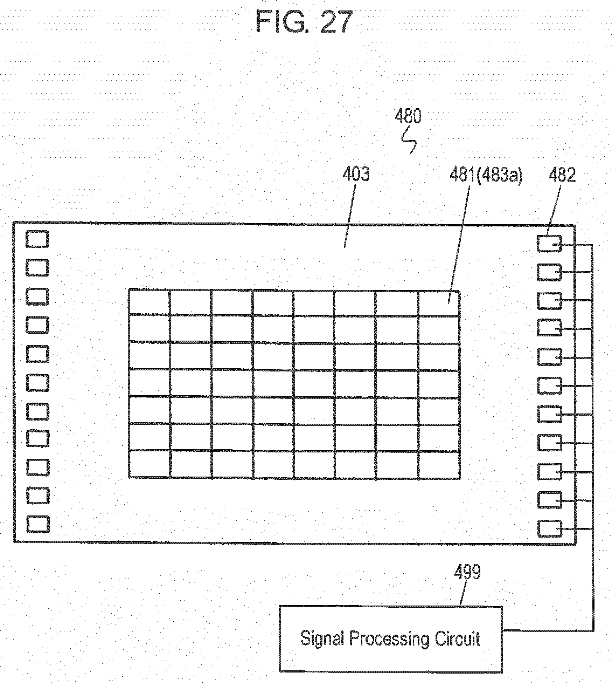

FIG. 27 is a schematic diagram of infrared sensor 480 according to Exemplary Embodiment 7.

Each pixel unit 481 includes infrared detection unit 483a and an MOS transistor that is a switching device for selecting a pixel. In infrared sensor 480, pixel units 481 are arranged in a two-dimensional array (matrix) on a surface of substrate 403. In accordance with Embodiment 7, as illustrated in FIG. 27, 8×8 pixel units 481 are arranged on a surface of substrate 403. The number and arrangement of pixel units 481, however, are not limited to this example. Infrared sensor 480 functions as detectors 221 and 222 according to Embodiment 1 or detectors 15 and 16 according to Embodiments 2 to 7. Pixel units 481 function as pixel units 200p according to Embodiment 1 and pixel units 24 according to Embodiments 2 to 7.

Infrared sensor 480 includes vertical read lines each corresponding to infrared detection units 483a in a corresponding row and used for reading signals from infrared detection units 483a. Here, drain electrodes of the MOS transistors are connected to infrared detection units 483a while source electrodes of the MOS transistors are connected to vertical read lines. Vertical read lines are connected in common. Infrared sensor 480 includes horizontal signal lines each corresponding to infrared detection units 483a in a corresponding column and used for switching the MOS transistors to turn on and off the MOS transistors. That is, gate electrodes of the MOS transistors are connected to the horizontal signal lines. The horizontal signal lines are connected in common. The horizontal signal lines are connected to a reference potential through reference bias lines corresponding to infrared detection units 483a in each row. The reference bias lines are connected in common via a common ground line. The vertical read lines, reference bias lines, horizontal signal lines, and common ground lines are electrically connected to pads 482. In this configuration, potentials of pads 482 are controlled to turn on the MOS transistors sequentially so that outputs of infrared detection units 483a can be read out sequentially. Signals from infrared detection units 483a are output to signal processing circuit 499 to be amplified by signal processing circuit 499.

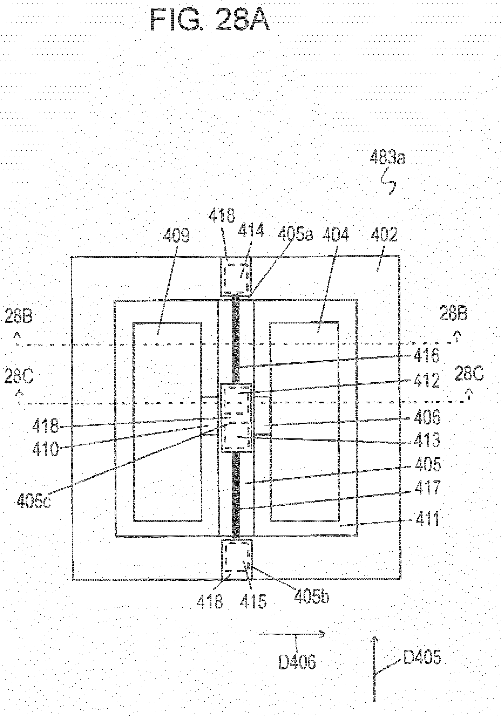

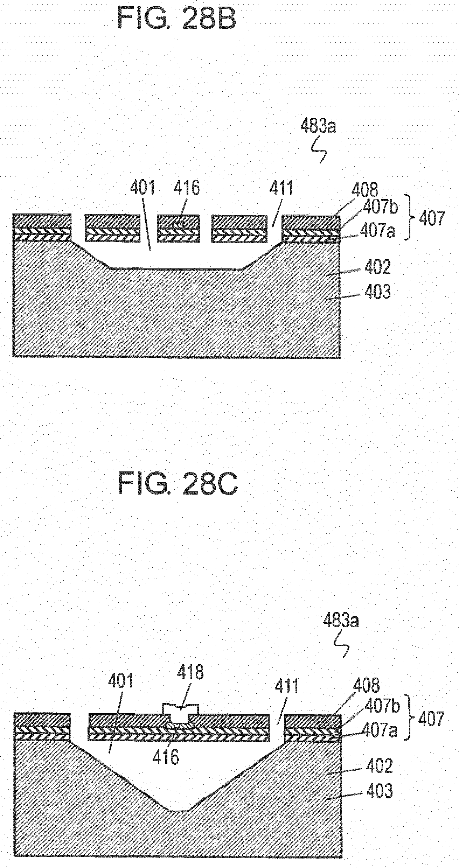

FIG. 28A is a top view of infrared detection unit 483a. FIG. 28B is a cross-sectional view of infrared detection unit 483a along line 28B-28B illustrated in FIG. 28A. FIG. 28C is a cross-sectional view of infrared detection unit 483a along line 28C-28C illustrated in FIG. 28A. Infrared sensor 480 includes substrate 403 having cavity 401 and support 402, infrared absorber 404 disposed above cavity 401, beam 405 disposed above cavity 401 and connecting support 402 to infrared absorber 404, and connector portion 406 connecting beam 405 to infrared absorber 404. Beam 405 faces cavity 401. Beam 405 is ends 405a and 405b opposite to each other connected to support 402, and extends from end 405a to end 405b in direction D405. Connector portion 406 extends from beam 405 to infrared absorber 404 in direction D406 different from direction D405. Beam 405 and connector portion 406 can be shortened so that warpage of infrared absorber 404 can be reduced. This configuration prevents damage caused by contact of infrared absorber 404 with substrate 403. Connector portion 406 preferably extends from center 405c of beam 405 toward infrared absorber 404. In accordance with the embodiments, the terms "middle" and "center" refer to degrees each including a margin in design, and mean substantial middle and substantial center, respectively.

As illustrated in FIGS. 28A to 28C, support 402 is provided with cold junction 414 and cold junction 415. Hot junctions 412 and 413 are provided on beam 405. Infrared detection unit 483a includes thermocouple 416 coupling cold junction 414 to hot junction 412 and thermocouple 417 coupling cold junction 415 to hot junction 413. Cold junction 414 is connected to a MOS transistor through wiring 418 and to signal processing circuit 499. Cold junction 415 is connected to a reference potential through wiring 418. Hot junction 412 is connected to hot junction 413 with wiring 418. Infrared absorber 404 is surrounded by slit 411.

As illustrated in FIGS. 28A to 28C, infrared detection unit 483a may further include infrared absorber 409 disposed above cavity 401. Infrared absorbers 404 and 409 are preferably provided symmetrically to each other with respect to beam 405. This configuration can reduce warpage of infrared absorbers 404 and 409, and allows the infrared detection unit to be easily formed.

An operation of infrared sensor 480 will be briefly described below. Infrared absorbers 404 and 409 of infrared detection unit 483a absorb infrared rays, i.e., heat. The absorbed heat is transmitted to beam 405 through connector portion 406. The heat reaching beam 405 increases temperatures of hot junctions 412 and 413. Substrate 403 does not absorb heat as much as infrared absorbers 404 and 409, and thus, the temperature rise of cold junctions 414 and 415 on substrate 403 is smaller than temperature rises of hot junctions 412 and 413. Accordingly, a temperature difference between each of hot junctions 412 and 413 and each of cold junctions 414 and 415 increases, and allows thermocouples 416 and 417 to produce a potential difference between cold junctions 414 and 415. This potential difference is supplied from infrared detection units 483a provided in pixel units 481 to signal processing circuit 499 through wiring 418 and pads 482. Signal processing circuit 499 can detect a temperature of each pixel unit 481 from the potential difference.

As illustrated in FIGS. 28A to 28C, direction D406 directed from beam 405 toward infrared absorber 404 in connector portion 406 is preferably perpendicular to direction D405 in which beam 405 extends. Since directions D405 and D406 are perpendicular to each other, infrared absorber 404 easily has a configuration symmetrical with respect to an axis extending in direction D406 so that warpage of infrared absorber 404 can be further reduced. The term "perpendicular" herein includes a margin in design, and means substantially vertical. The term "symmetrical" herein includes a margin in design, and means substantially symmetrical.

As illustrated in FIGS. 28A to 28C, Infrared absorber 404 is preferably connected only to beam 405. This configuration increases the total surface area of the infrared absorber so that sensitivity of infrared sensor 480 can be enhanced.

As illustrated in FIGS. 28A to 28C, the surface area of infrared absorber 404 is preferably larger than the surface area of beam 405. This configuration can increase the total surface area of infrared absorber 404 so that sensitivity of infrared sensor 480 can be enhanced.

As illustrated in FIGS. 28A to 28C, the length of thermocouple 416 coupling cold junction 414 to hot junction 412 is preferably equal to the length of thermocouple 417 coupling cold junction 415 to hot junction 413. As the lengths of the thermocouples increase, thermal insulation between the hot junction and the cold junction increases, and thus, sensitivity of the Infrared sensor increases. In the case where a thermal conductivity of a material of thermocouple 416 is equal to a thermal conductivity of a material of thermocouple 417, sensitivity of heat quantity detected by infrared absorber 404 depends largely on a shorter one of thermocouples 416 and 417. Thus, the configuration in which thermocouples 416 and 417 have the same length can further enhance sensitivity of infrared sensor 480. The term "equal" herein includes a margin in design, and means substantially equal. As illustrated in FIGS. 28A to 28C, in a plan view, beam 405 is preferably symmetrical with respect to an axis perpendicular to direction D405 in which beam 405 extends. This configuration can further reduce warpage of infrared absorber 404 and beam 405, and allows the unit to be easily formed.

As illustrated in FIGS. 28A to 28C, a distance between hot junction 412 and hot junction 413 is preferably smaller than a length of connector portion 406 in direction D405. Reduction of the distance between hot junction 412 and hot junction 413 can increase the lengths of thermocouples 416 and 417 and increase thermal insulation between hot junction 412 and cold junction 414 and thermal insulation between hot junction 413 and cold junction 415 so that sensitivity of infrared sensor 480 can be further enhanced.

As illustrated in FIGS. 28A to 28C, the length of connector portion 406 in direction D405 is preferably smaller than the length of infrared absorber 404 in direction D405. The shorter length of connector portion 406 in direction D405 can reduce dissipation of heat absorbed in infrared absorber 404 that is otherwise easily dissipated so that sensitivity of infrared sensor 480 can be further enhanced.

As illustrated in FIGS. 28A to 28C, slit 411 is preferably disposed between beam 405 and infrared absorber 404. This configuration can reduce dissipation of heat absorbed in infrared absorber 404 so that sensitivity of infrared sensor 480 can be further enhanced.

As illustrated in FIGS. 28A to 28C, infrared detection unit 483a may further include infrared absorber 409 disposed above cavity 401 and connector portion 410 connecting infrared absorber 409 to beam 405. Infrared absorber 404 and infrared absorber 409 are preferably provided symmetrically to each other with respect to beam 405. This configuration can further reduce warpage of infrared absorber 404 and infrared absorber 409, and allows the unit to be easily formed.

Each of thermocouple 416 and thermocouple 417 is preferably made of a material containing silicon germanium.

The silicon germanium may preferably be expressed as $Si_{1-X}Ge_X$ (where $0.15 \leq X \leq 0.85$). To reduce warpage of infrared absorber 404, beam 405 and connector portion 406 are shortened. Thus, the lengths of thermocouples 416 and 417 are also reduced. The reduced lengths of thermocouples 416 and 417 facilitate transmission of heat absorbed in infrared absorbers 404 and 409 to cold junctions 414 and 415. Since thermocouples 416 and 417 are made of material containing silicon germanium, thermal conductivity can be smaller than a material containing only one of silicon or germanium. This configuration reduces transmission of heat absorbed in infrared absorbers 404 and 409 to cold junctions 414 and 415 so that sensitivity of infrared sensor 480 can be enhanced.

Thermocouple 416 is preferably made of material with an N-type conductivity while thermocouple 417 is preferably made of material with a P-type conductivity. This configuration allows thermocouples 416 and 417 to have Seebeck coefficients having opposite polarities, hence exhibiting the Seebeck effect.

Substrate 403 is preferably made of silicon, that is, may mainly contain silicon while containing other substances.

As illustrated in FIGS. 28A to 28C, wiring 418 connecting hot junction 412 to hot junction 413 is preferably disposed above hot junctions 412 and 413. Cold junction 414 or 415 is preferably connected to signal processing circuit 499 that processes a signal from infrared absorber 404. This configuration is preferable since signal processing circuit 499 can process a signal detected by infrared absorber 404.

As illustrated in FIGS. 28A to 28C, infrared absorbers 404 and 409 and beam 405 preferably have the same film structure. Specifically, each of infrared absorbers 404 and 409 and beam 405 preferably has a laminated structure of films 407 and 408 stacked on each other. Film 407 preferably has a structure in which silicon oxide film 407a of silicon oxide is stacked on silicon nitride film 407b of silicon nitride. Silicon oxide film 407a is provided on substrate 403, silicon oxide film 407b is provided on silicon oxide film 407b, and film 408 is provided on silicon nitride film 407b. Film 408 is preferably made of a silicon oxide film, such as boron-doped phosopho-silicate glass (BPSG) film. Film 408 is preferably thicker than film 407. A passivation film may be formed on film 408 to cover wiring 418. The passivation film has a laminated structure including a phosopho-silicate glass (PSG) film and a non-doped silicate glass (NSG) film on the PSG film.

Exemplary Embodiment 8

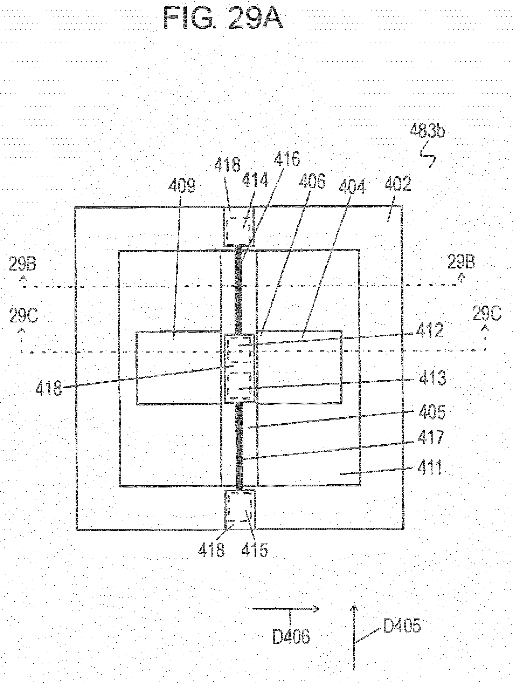

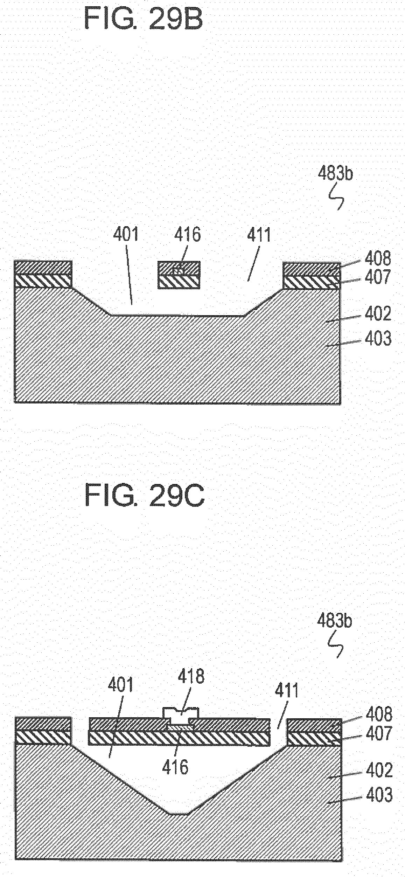

FIG. 29A is a top view of infrared detection unit 483b of an infrared sensor according to Exemplary Embodiment 8. FIG. 29B is a cross-sectional view of infrared detection unit 483b along line 29B-29B illustrated in FIG. 29A. FIG. 29C is a cross-sectional view of infrared detection unit 483b along line 29C-29C illustrated in FIG. 29A. In FIGS. 29A to 29C, components identical to those of infrared detection unit 483a according to Embodiment 7 illustrated in FIGS. 28A to 28C are denoted by the same reference numerals. Similarly to infrared detection unit 483a according to Embodiment 7, infrared detection unit 483b is provided in pixel unit 481 of infrared sensor 480 illustrated in FIG. 27, and functions similarly to infrared detection unit 483a.

As illustrated in FIGS. 29A to 29C, in infrared detection unit 483b according to Embodiment 8, the length of beam 405 of connector portion 406 in direction D405 is equal to the length of infrared absorbers 404 and 409 in direction D405.

The lengths of infrared absorbers 404 and 409 in direction D405 are smaller than those in Embodiment 7. This configuration can advantageously reduce warpage of infrared absorbers 404 and 409 in direction D405 in which beam 405 extends.

The length of connector portion 406 in direction D405 is larger than that in Embodiment 7. The strength of connector portion 406 is increased so that reliability of the infrared sensor can be enhanced.

As described above, infrared detection unit 483b according to Embodiment 8 can adjust its configuration depending on priorities of sensitivity and reliability.

Exemplary Embodiment 9

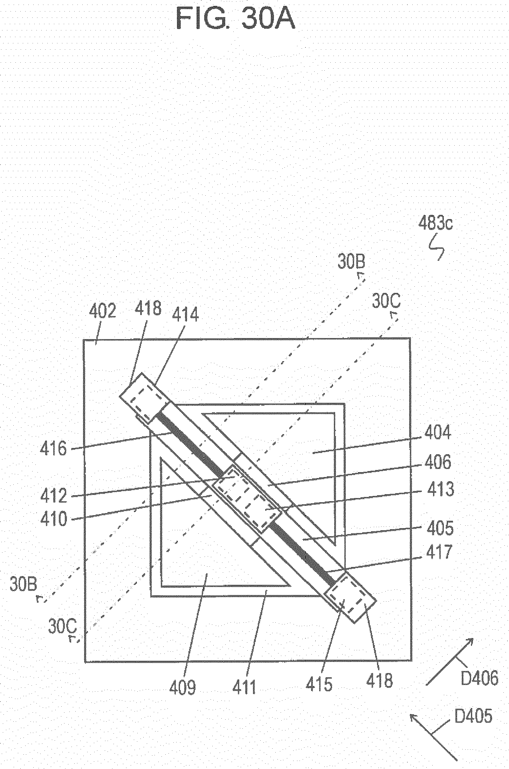

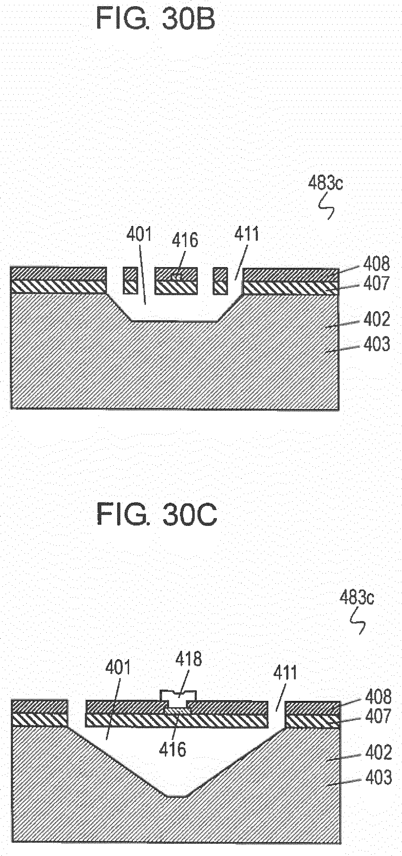

FIG. 30A is a top view of infrared detection unit 483c of an infrared sensor according to Exemplary Embodiment 9. FIG. 30B is a cross-sectional view of infrared detection unit 483c along line 30A-30A illustrated in FIG. 30A. FIG. 30C is a cross-sectional view of infrared detection unit 483c along line 30C-30C illustrated in FIG. 30A. In FIGS. 30A to 30C, components identical to those of infrared detection unit 483a according to Embodiment 7 illustrated in FIGS. 28A to 28C are denoted by the same reference numerals. Similarly to infrared detection unit 483a according to Embodiment 7, infrared detection unit 483c is provided in pixel unit 481 of infrared sensor 480 illustrated in FIG. 27 and functions similarly to infrared detection unit 483a.

In infrared detection unit 483c according to Embodiment 9 illustrated in FIGS. 30A to 30C, substrate 403 has a rectangular shape, and beam 405 extends along a diagonal line of the rectangular shape of substrate 403. Thus, thermocouple 416 and thermocouple 417 can be longer than those of Embodiment 4. This configuration increases the lengths of thermocouples 416 and 417 while reducing warpage of infrared absorbers 404 and 409 so that sensitivity of infrared detection unit 483c can be enhanced advantageously. The sensitivity depends not only on the lengths of thermocouples 416 and 417 but also on the areas of infrared absorbers 404 and 409. In the case where it is difficult to reduce thermal conductivities of thermocouples 416 and 417 relatively, the areas of infrared absorbers 404 and 409 and the lengths of thermocouples 416 and 417 are adjusted so that sensitivity can be set at an optimum value.

As described above, infrared detection unit 483c according to Embodiment 9 can adjust its material and configuration in order to obtain an optimum sensitivity.

Exemplary Embodiment 10

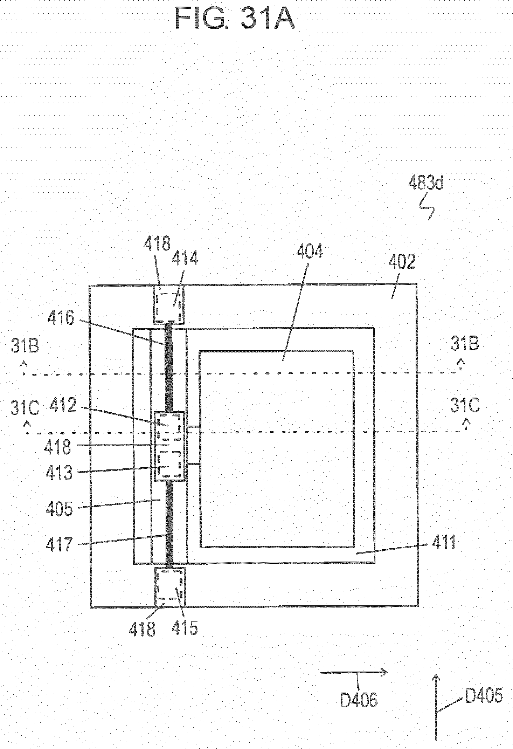

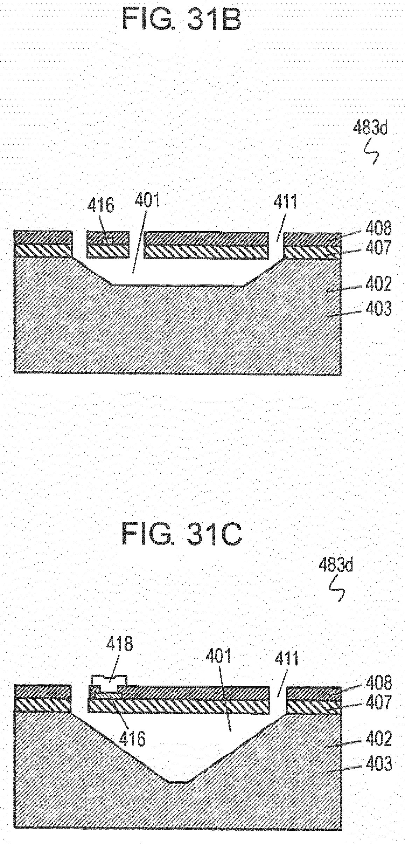

FIG. 31A is a top view of infrared detection unit 483d of an infrared sensor according to Exemplary Embodiment 10. FIG. 31B is a cross-sectional view of infrared detection unit 483d along line 31B-31B illustrated in FIG. 31A. FIG. 31C is a cross-sectional view of infrared detection unit 483d along line 31C-31C illustrated in FIG. 31A. In FIGS. 31A to 31C, components identical to those of infrared detection unit 483a according to Embodiment 7 illustrated in FIGS. 28A to 28C are denoted by the same reference numerals. Similarly to infrared detection unit 483a according to Embodiment 7, infrared detection unit 483d is provided in pixel unit 481 of infrared sensor 480 illustrated in FIG. 27 and functions similarly to infrared detection unit 483a.

As illustrated in FIGS. 31A to 31C, infrared detection unit 483d according to Embodiment 10 includes only infrared absorber 404 out of infrared absorbers 404 and 409, and does not have a configuration symmetrical with respect beam 405. The total area of slit 411 can be smaller than that of Embodiment 7. Thus, the total area of infrared absorber 404 can be larger than that of Embodiment 7. This configuration can enhance sensitivity of infrared sensor 480 according to the increased amount of total area of infrared absorber 404.

As described above, infrared detection unit 483d according to Embodiment 10 can adjust its configuration in order to obtain an optimum sensitivity.

Exemplary Embodiment 11

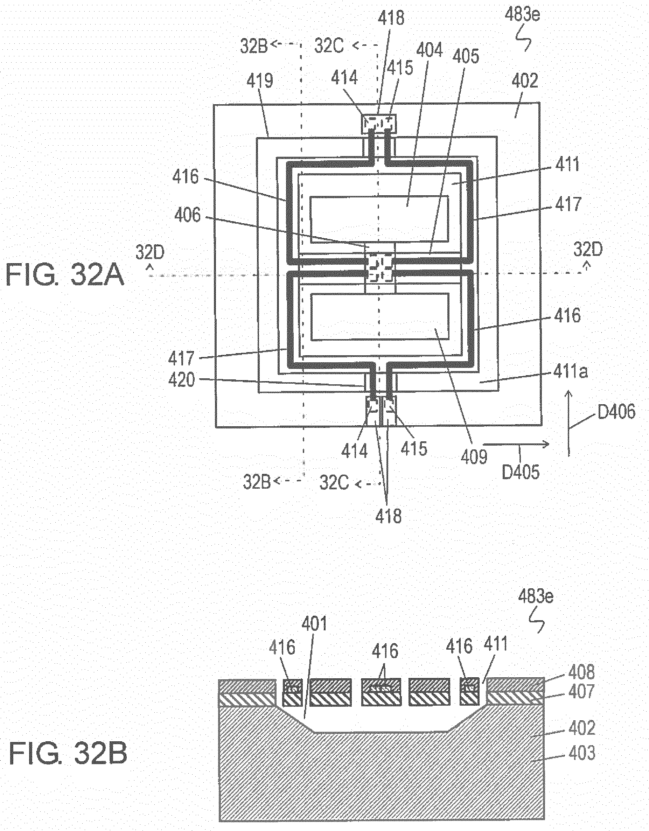

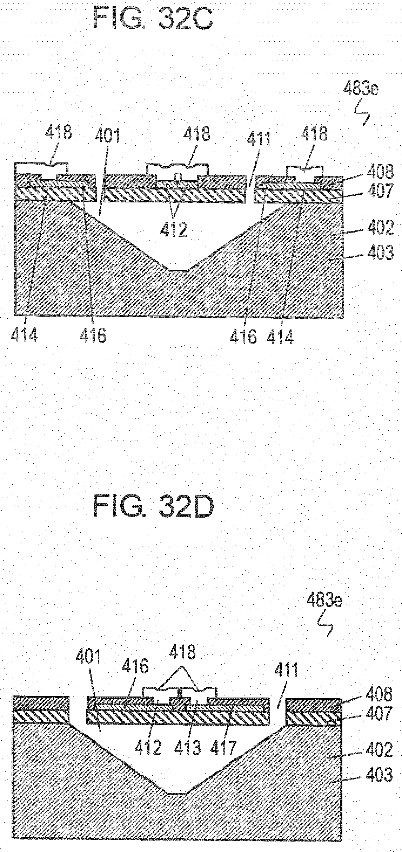

FIG. 32A is a top view of infrared detection unit 483e of an infrared sensor according to Exemplary Embodiment 11. FIG. 32B is a cross-sectional view of infrared detection unit 483e along line 32B-32B illustrated in FIG. 32A. FIG. 32C is a cross-sectional view of infrared detection unit 483e along line 32C-32C illustrated in FIG. 32A. FIG. 32D is a cross-sectional view of infrared detection unit 483e along line 32D-32D illustrated in FIG. 32A. In FIGS. 32A to 32D, components identical to those of infrared detection unit 483a according to Embodiment 7 illustrated in FIGS. 28A to 28C are denoted by the same reference numerals. Similar to infrared detection unit 483a according to Embodiment 7, infrared detection unit 483e is provided in pixel unit 481 of infrared sensor 480 illustrated in FIG. 27 and functions similarly to infrared detection unit 483a.

As illustrated in FIGS. 32A to 32D, infrared detection unit 483e according to Embodiment 11 further includes beam 419 disposed above cavity 401 and connecting support 402 to beam 405. In a plan view, beam 419 surrounds infrared absorber 404. This configuration can increase the lengths of thermocouples 416 and 417. Thus, the lengths of thermocouples 416 and 417 can be increased while reducing warpage of infrared absorbers 404 and 409 so that sensitivity of infrared sensor 480 can be enhanced. The sensitivity depends not only on the lengths of thermocouples 416 and 417 but also on the area of infrared absorber 404. By adjusting the area of infrared absorber 404 and the lengths of thermocouples 416 and 417, an optimum sensitivity can be obtained.

As described above, infrared detection unit 483e according to Embodiment 11 can adjust its configuration in order to obtain an optimum sensitivity.

As illustrated in FIGS. 32A to 32D, beam 419 is preferably surrounded by slit 411a. Slit 411 inside of beam 419 has preferably a smaller area than slit 411a outside of beam 419. Beam 419 is connected to support 402 via connector portion 420. The length of connector portion 406 in direction D406 perpendicular to direction D405 in which beam 405 extends is preferably smaller than the length of connector portion 420 in direction D406. This configuration further reduces warpage of infrared absorber 404.

In conventional infrared sensor disclosed in PTL 3, each of the beam and the infrared absorber has a hollow thin film structure including a stack of films where warpage occurs due to residual stress caused by fabrication processes. In this infrared sensor, the infrared absorber is supported by two different beams, and the distance between the two supports is relatively long. Thus, residual stress increases warpage, resulting in the possibility of damage of the beam or the infrared absorber.

Each of infrared detection units 483a to 483e according to Embodiments 7 to 11 reduces warpage of infrared absorber 404 (409) so that film damage of infrared absorber 404 (409) can be reduced, and reliable infrared sensor 480 can be provided.

Infrared sensor 480 includes substrate 403 having cavity 401 and including 402, infrared absorber 404 disposed above cavity 401, beam 405 disposed above cavity 401, and connector portion 406 connecting beam 405 to infrared absorber 404. Beam 405 connects support 402 to infrared absorber 404 and extends in direction D405. Connector portion 406 extends in direction D406 directed extends from center 405c of beam 405 toward infrared absorber 404 and is different from direction D405.

Direction D406 may be perpendicular to direction D405.

Infrared absorber 404 may be connected only to beam 405.

Infrared absorber 404 may have a surface area larger than beam 405.

The length of connector portion 406 in direction D405 may be smaller than the length of infrared absorber 404 in direction D405.

Slit 411 may be provided between beam 405 and infrared absorber 404.

Infrared sensor 480 may further include infrared absorber 409 disposed above cavity 401. In this case, infrared absorbers 404 and 409 are symmetrical to each other with respect to beam 405.

In a plan view, beam 405 may be symmetrical with respect to an axis perpendicular to direction D405.

Infrared sensor may further include thermocouple 416 and thermocouple 417. Thermocouple 416 includes cold junction 414 provided on support 402 and hot junction 412 provided on beam 405. Thermocouple 417 includes cold junction 415 provided on support 402 and hot junction 413 provided on beam 405. The length of thermocouple 416 from cold junction 414 to hot junction 412 is equal to the length of thermocouple 417 from cold junction 415 to hot junction 413.

Infrared sensor may further include wiring 418 connecting hot junction 412 to hot junction 413 and signal processing circuit 499 that processes a signal from infrared absorber 404.

Each of thermocouple 416 and thermocouple 417 may be made of material containing silicon germanium.

Thermocouple 416 may be made of material with an N-type conductivity while and thermocouple 417 may be made of material with a -type conductivity.

The distance between hot junction 412 and hot junction 413 may be smaller than the length of connector portion 406 in direction D405.

Infrared sensor 480 may further include beam 419 disposed above cavity 401 and connecting support 402 and beam 405 to each other. In this case, beam 419 surrounds infrared absorber 404 in a plan view.

Substrate 403 may be made of silicon.

REFERENCE MARKS IN THE DRAWINGS

11, 51, 61, 71, 81 detection device
12 vehicle
13,82 detector
14 scanning part
15 detector (first detector)
16 detector (second detector)
17, 52, 62, 72, 83 vehicle control device
20 occupant
21 processor
22 air conditioner
23 controller
24 pixel unit
25 driver seat
26 passenger seat
27 windshield
28 rear windshield
29 floor
30 ceiling
31b, 91b B-pillar
32 detectable range
34 detectable range after scan
35 rotation axis
36 driver
37 passenger
38 processing unit
39 setting unit
220 detection device

221 detector (first detector)
222 detector (second detector)
223 object (occupant)
224 processor
225 detectable range
226 detectable range
227 line
228 plane
229a, 229b axis
230 vehicle control device
231 vehicle
232 driver
233 driver seat
234a A-pillar
234b B-pillar
235 passenger
236 passenger seat
237a A-pillar
237b B-pillar
238 electronic device
239 occupant
240 seat
241 windshield
242 head
243 switch
244 operation panel
401 cavity
402 support
403 substrate
404 infrared absorber (first infrared absorber)
405 beam (first beam)
406 connector portion (first connector portion)
409 infrared absorber (second infrared absorber)
410 connector portion (second connector portion)
411 slit
412 hot junction (first hot junction)
413 hot junction (second hot junction)
414 cold junction (first cold junction)
415 cold junction (second cold junction)
416 thermocouple (first thermocouple)
417 thermocouple (second thermocouple)
418 wiring
419 beam (second beam)
480 infrared sensor
481 pixel unit
483a-483e infrared detection unit

**Claims**

1. A detection device configured to be used with a vehicle including a cabin, a ceiling, a driver seat, a passenger seat, and a plurality of pillars, the detection device comprising:

   a detector disposed on the ceiling or the plurality of pillars of the vehicle, the detector being configured to detect an object while not contacting the object; and
   a scanning unit that moves the detector for scan.

2. The detection device of claim 1, wherein the detector includes a first detector that is closer to the driver seat than to the passenger seat and a second detector that is closer to the passenger seat than to the driver seat.

3. The detection device of claim 2,
   wherein the plurality of pillars include a plurality of B-pillars, and
   wherein the first detector and the second detector are disposed on the plurality of B-pillars.

4. The detection device of claim 3,
   wherein the vehicle further includes a windshield facing the cabin and a rear windshield facing the cabin, and
   wherein the scanning unit moves the first detector and the second detector for scan from a direction toward the windshield to a direction toward the rear windshield.

5. The detection device of claim 3,
   wherein the vehicle further includes a windshield facing the cabin, and
   wherein the first detector and the second detector are tilted toward the windshield with respect to a direction connecting the first detector to the second detector.

6. The detection device of claim 5,
   wherein the vehicle further includes a floor facing the cabin, and
   wherein the scanning unit moves the first detector and the second detector for scan from a direction toward the floor to a direction toward the ceiling.

7. The detection device of claim 2, wherein the first detector and the second detector are disposed between the driver seat and the passenger seat viewing from the ceiling.

8. The detection device of claim 7,
   wherein the vehicle further includes a windshield facing the cabin and a rear windshield facing the cabin, and
   wherein the scanning unit moves the first detector and the second detector for scan from a direction toward the windshield to a direction toward the rear windshield.

9. The detection device of claim 7,
   wherein the vehicle further includes a floor facing the cabin, and
   wherein the scanning unit moves the first detector and the second detector for scan from a direction toward the floor to a direction toward the ceiling.

10. The detector device of claim 1, wherein the scanning unit moves the detector for scan in a direction connecting the driver seat to the passenger seat.

11. The detection device of claim 1,
    wherein the detector includes a first detector and a second detector, the first detector being closer to the driver seat than to the passenger seat, the second detector being closer to the passenger seat than to the driver seat,
    the detection device further comprising a processor configured to detect, based on outputs of the first detector and the second detector, a movement of the object in a plane having a normal line connecting the first detector to the second detector.

12. The detection device of claim 11, wherein each of the first detector and the second detector includes an infrared sensor including a plurality of infrared detecting elements arranged in a one-dimensional array or a two-dimensional array.

13. The detection device of claim 11, wherein the processor detects a distance D between the object and each of the first detector and the second detector in a direction perpendicular to a line connecting the first detector to the second detector with a distance L between the first detector and the second detector, a tilt angle $\alpha$ of the first detector, a tilt angle $\beta$ of the second detector, a focal length f of the first detector and the second detector, a distance Ca from a center of a light-receiving surface of the first detector to a thermal centroid of the object, and a distance Cb from a center of a light-receiving surface of the second detector to a thermal centroid of the object by a formula:

$$D = \frac{L \cdot f}{Ca \cdot \cos\alpha + f \cdot \sin\alpha + Cb \cdot \cos\beta + f \cdot \sin\beta \cdot}$$

14. The detection device of claim 1,
wherein the detector includes an infrared sensor which includes:

a substrate including a cavity and a support;
a first infrared absorber disposed on the cavity;
a first beam disposed on the cavity and extending in a first direction, the first beam connecting the support to the first infrared absorber; and
a first connector portion connecting the first beam to the first infrared absorber, and

wherein the first connector portion extends from a center of the first beam toward the first infrared absorber in a second direction different from the first direction.

15. The detection device of claim 14, wherein the second direction is perpendicular to the first direction.

16. The detection device of claim 14 or 15, wherein the first infrared absorber is connected only to the first beam.

17. The detection device of any one of claims 14 to 16, wherein the first infrared absorber has a surface area larger than a surface area of the first beam.

18. The detection device of any one of claims 14 to 17, wherein a length of the first connector portion in the first direction is smaller than a length of the first infrared absorber in the first direction.

19. The detection device of any one of claims 14 to 18, wherein a slit is provided between the first beam and the infrared absorber.

20. The detection device of any one of claims 14 to 19,
wherein the infrared sensor further includes a second infrared absorber disposed on the cavity, and
wherein the first infrared absorber and the second infrared absorber are disposed symmetrically to each other with respect to the first beam.

21. The detection device of any one of claims 14 to 20, wherein the first beam is symmetrical with respect to an axis perpendicular to the first direction in a plan view.

22. The detection device of any one of claims 14 to 21,
wherein the infrared sensor further includes:

a first thermocouple including a first cold junction disposed on the support and a first hot junction disposed on the first beam; and
a second thermocouple including a second cold junction disposed on the support and a second hot junction disposed on the first beam, and

wherein a length of the first thermocouple from the first cold junction to the first hot junction is equal to a length of the second thermocouple from the second cold junction to the second hot junction.

23. The detection device of claim 22, wherein the infrared sensor further includes:

a wiring disposed on the first hot junction and the second hot junction, the wiring connecting the first hot junction to the second hot junction, and
a signal processing circuit connected to one of the first cold junction and the second cold junction, the signal processing circuit configured to process a signal from the first infrared absorber.

24. The detection device of claim 22 or 23, wherein each of the first thermocouple and the second thermocouple is made of material containing silicon germanium.

**25.** The detection device of any one of claims 22 to 24, wherein the first thermocouple is made of material with an N-type conductivity, and the second thermocouple is made of material with a P-type conductivity.

**26.** The detection device of any one of claims 22 to 25, wherein a distance between the first hot junction and the second hot junction is smaller than a length of the first connector portion in the first direction.

**27.** The detection device of any one of claims 14 to 26,
wherein the infrared sensor further includes a second beam disposed on the cavity and connecting the support to the first beam, and
wherein the second beam surrounds the first infrared absorber in a plan view.

**28.** The detection device of any one of claims 14 to 27, wherein the substrate is made of silicon.

**29.** A vehicle control device comprising:

the detection device of any one of claims 1 to 10; and
a controller configured to:

estimate first thermal feeling of the object based on an output of the detection device, and
control a first air conditioner installed to the vehicle in accordance with the first thermal feeling.

**30.** The vehicle control device of claim 29,
wherein the first air conditioner is disposed close to the driver seat,
wherein the controller is configured to:

estimate second thermal feeling of an object on the passenger seat,
control the first air conditioner in accordance with the first thermal feeling, and
control a second air conditioner disposed close to the passenger seat of the vehicle in accordance with the second thermal feeling.

**31.** A vehicle control device configured to be installed to a vehicle having a first electronic device installed thereto, the vehicle control device comprising:

the detection device of any one of claims 11 to 13; and
a processor that controls the first electronic device based on outputs of the first detector and the second detector, wherein the first detector and the second detector are disposed in the cabin of the vehicle.

**32.** The vehicle control device of claim 31,
wherein the vehicle includes a windshield, and
wherein the first detector and the second detector are tilted toward the windshield with respect to a direction connecting the first detector to the second detector.

**33.** The vehicle control device of claim 31,
wherein the vehicle further includes a plurality of A-pillars and a plurality of B-pillars, and
wherein each of the first detector and the second detector is disposed on the plurality of A-pillars or the plurality of B-pillars.

**34.** The vehicle control device of claim 31,
wherein the first detector is disposed such that the object is entirely put within a detectable range of the first detector when the object is close to the second detector, and
wherein the second detector is disposed such that the object is entirely put within a detectable range of the second detector when the object is close to the first detector.

**35.** The vehicle control device of claim 31, wherein a distance between the first detector and the second detector is equal to or larger than 500 mm and is equal to or smaller than 1500 mm.

**36.** The vehicle control device of claim 31, wherein the processor determines, based on outputs of the first detector and the second detector, which one of the first detector or the second detector is closer to the object.

**37.** The vehicle control device of claim 31,
wherein a second electronic device is installed to the vehicle, and
wherein, when the vehicle control device detects that the object approaches one of the first electronic device and the second electronic device, the vehicle control device controls the one of the first electronic device and the second electronic device.

**Amended claims under Art. 19.1 PCT**

**1.** (Amended) A detection device configured to be used with a vehicle including a cabin, a ceiling, a driver seat, a passenger seat, a floor, and a plurality of pillars, the detection device comprising:

a detector disposed on the ceiling or the plurality of pillars of the vehicle, the detector being configured to detect an object while not contacting the object; and
a scanning unit that moves the detector for scan as to locate the floor in a detectable range of the detector.

**2.** The detection device of claim 1, wherein the detector includes a first detector that is closer to the driver seat than to the passenger seat and a second detector that is closer to the passenger seat than to the driver seat.

**3.** The detection device of claim 2,
wherein the plurality of pillars include a plurality of B-pillars, and
wherein the first detector and the second detector are disposed on the plurality of B-pillars.

**4.** The detection device of claim 3,
wherein the vehicle further includes a windshield facing the cabin and a rear windshield facing the cabin, and
wherein the scanning unit moves the first detector and the second detector for scan from a direction toward the windshield to a direction toward the rear windshield.

**5.** The detection device of claim 3,
wherein the vehicle further includes a windshield facing the cabin, and
wherein the first detector and the second detector are tilted toward the windshield with respect to a direction connecting the first detector to the second detector.

**6.** (Amended) The detection device of claim 5,
wherein the floor faces the cabin, and
wherein the scanning unit moves the first detector and the second detector for scan from a direction toward the floor to a direction toward the ceiling.

**7.** The detection device of claim 2, wherein the first detector and the second detector are disposed between the driver seat and the passenger seat viewing from the ceiling.

**8.** The detection device of claim 7,
wherein the vehicle further includes a windshield facing the cabin and a rear windshield facing the cabin, and
wherein the scanning unit moves the first detector and the second detector for scan from a direction toward the windshield to a direction toward the rear windshield.

**9.** (Amended) The detection device of claim 7,
wherein the floor faces the cabin, and
wherein the scanning unit moves the first detector and the second detector for scan from a direction toward the floor to a direction toward the ceiling.

**10.** The detector device of claim 1, wherein the scanning unit moves the detector for scan in a direction connecting the driver seat to the passenger seat.

**11.** The detection device of claim 1,

wherein the detector includes a first detector and a second detector, the first detector being closer to the driver seat than to the passenger seat, the second detector being closer to the passenger seat than to the driver seat, the detection device further comprising a processor configured to detect, based on outputs of the first detector and the second detector, a movement of the object in a plane having a normal line connecting the first detector to the second detector.

**12.** The detection device of claim 11, wherein each of the first detector and the second detector includes an infrared sensor including a plurality of infrared detecting elements arranged in a one-dimensional array or a two-dimensional array.

**13.** The detection device of claim 11, wherein the processor detects a distance D between the object and each of the first detector and the second detector in a direction perpendicular to a line connecting the first detector to the second detector with a distance L between the first detector and the second detector, a tilt angle $\alpha$ of the first detector, a tilt angle $\beta$ of the second detector, a focal length f of the first detector and the second detector, a distance Ca from a center of a light-receiving surface of the first detector to a thermal centroid of the object, and a distance Cb from a center of a light-receiving surface of the second detector to a thermal centroid of the object by a formula:

$$D = \frac{L \cdot f}{Ca \cdot \cos\alpha + f \cdot \sin\alpha + Cb \cdot \cos\beta + f \cdot \sin\beta}.$$

**14.** The detection device of claim 1,
wherein the detector includes an infrared sensor which includes:

a substrate including a cavity and a support;
a first infrared absorber disposed on the cavity;
a first beam disposed on the cavity and extending in a first direction, the first beam connecting the support to the first infrared absorber; and
a first connector portion connecting the first beam to the first infrared absorber, and

wherein the first connector portion extends from a center of the first beam toward the first infrared absorber in a second direction different from the first direction.

**15.** The detection device of claim 14, wherein the second direction is perpendicular to the first direction.

**16.** The detection device of claim 14 or 15, wherein the first infrared absorber is connected only to the first beam.

**17.** The detection device of any one of claims 14 to 16, wherein the first infrared absorber has a surface area larger than a surface area of the first beam.

**18.** The detection device of any one of claims 14 to 17, wherein a length of the first connector portion in the first direction is smaller than a length of the first infrared absorber in the first direction.

**19.** The detection device of any one of claims 14 to 18, wherein a slit is provided between the first beam and the infrared absorber.

**20.** The detection device of any one of claims 14 to 19,
wherein the infrared sensor further includes a second infrared absorber disposed on the cavity, and
wherein the first infrared absorber and the second infrared absorber are disposed symmetrically to each other with respect to the first beam.

**21.** The detection device of any one of claims 14 to 20, wherein the first beam is symmetrical with respect to an axis perpendicular to the first direction in a plan view.

**22.** The detection device of any one of claims 14 to 21,
wherein the infrared sensor further includes:

a first thermocouple including a first cold junction disposed on the support and a first hot junction disposed on the first beam; and

a second thermocouple including a second cold junction disposed on the support and a second hot junction disposed on the first beam, and

wherein a length of the first thermocouple from the first cold junction to the first hot junction is equal to a length of the second thermocouple from the second cold junction to the second hot junction.

23. The detection device of claim 22, wherein the infrared sensor further includes:

a wiring disposed on the first hot junction and the second hot junction, the wiring connecting the first hot junction to the second hot junction, and

a signal processing circuit connected to one of the first cold junction and the second cold junction, the signal processing circuit configured to process a signal from the first infrared absorber.

24. The detection device of claim 22 or 23, wherein each of the first thermocouple and the second thermocouple is made of material containing silicon germanium.

25. The detection device of any one of claims 22 to 24, wherein the first thermocouple is made of material with an N-type conductivity, and the second thermocouple is made of material with a P-type conductivity.

26. The detection device of any one of claims 22 to 25, wherein a distance between the first hot junction and the second hot junction is smaller than a length of the first connector portion in the first direction.

27. The detection device of any one of claims 14 to 26, wherein the infrared sensor further includes a second beam disposed on the cavity and connecting the support to the first beam, and wherein the second beam surrounds the first infrared absorber in a plan view.

28. The detection device of any one of claims 14 to 27, wherein the substrate is made of silicon.

29. A vehicle control device comprising:

the detection device of any one of claims 1 to 10; and
a controller configured to:

estimate first thermal feeling of the object based on an output of the detection device, and
control a first air conditioner installed to the vehicle in accordance with the first thermal feeling.

30. The vehicle control device of claim 29,
wherein the first air conditioner is disposed close to the driver seat,
wherein the controller is configured to:

estimate second thermal feeling of an object on the passenger seat,
control the first air conditioner in accordance with the first thermal feeling, and
control a second air conditioner disposed close to the passenger seat of the vehicle in accordance with the second thermal feeling.

31. A vehicle control device configured to be installed to a vehicle having a first electronic device installed thereto, the vehicle control device comprising:

the detection device of any one of claims 11 to 13; and
a processor that controls the first electronic device based on outputs of the first detector and the second detector, wherein the first detector and the second detector are disposed in the cabin of the vehicle.

32. The vehicle control device of claim 31,
wherein the vehicle includes a windshield, and
wherein the first detector and the second detector are tilted toward the windshield with respect to a direction connecting the first detector to the second detector.

33. The vehicle control device of claim 31,
    wherein the vehicle further includes a plurality of A-pillars and a plurality of B-pillars, and
    wherein each of the first detector and the second detector is disposed on the plurality of A-pillars or the plurality of B-pillars.

34. The vehicle control device of claim 31,
    wherein the first detector is disposed such that the object is entirely put within a detectable range of the first detector when the object is close to the second detector, and
    wherein the second detector is disposed such that the object is entirely put within a detectable range of the second detector when the object is close to the first detector.

35. The vehicle control device of claim 31, wherein a distance between the first detector and the second detector is equal to or larger than 500 mm and is equal to or smaller than 1500 mm.

36. The vehicle control device of claim 31, wherein the processor determines, based on outputs of the first detector and the second detector, which one of the first detector or the second detector is closer to the object.

37. The vehicle control device of claim 31,
    wherein a second electronic device is installed to the vehicle, and
    wherein, when the vehicle control device detects that the object approaches one of the first electronic device and the second electronic device, the vehicle control device controls the one of the first electronic device and the second electronic device.

## FIG. 1

## FIG. 2

## FIG. 3A

## FIG. 3B

## FIG. 3C

# FIG. 4

230

221 — Detector

222 — Detector

224
Processor

238
Electronic Deveice

238
Electronic Deveice

# FIG. 5A

231

241

237a

234a

D231a

D231b

237b

231b

234b

# FIG. 5B

# FIG. 6

# FIG. 7

# FIG. 8

FIG. 9

# FIG.10A

FIG. 10B

# FIG. 11

# FIG. 12

EP 3 232 236 A1

## FIG. 13

## FIG. 14

36

# FIG. 15

```
                              52

15 ─ Detector          Detector ─ 16

18 ─ Detector          Detector ─ 19
     I/F Circuit        I/F Circuit
                                      39        21

38 ─ Processing Unit ◄── Setting Unit

23 ─ Controller

22 ─ Louver    Compressor    Fan

     40          41           42
```

# FIG. 16

FIG. 17

# FIG. 18

62

| 15 | Detector | | Detector | 16 |

| 18 | Detector I/F Circuit | | Detector I/F Circuit | 19 |

39    21

38   Procesing Unit   ←   Setting Unit

23   Controller

22

| Louver | Compressor | Fan |

40       41       42

# FIG. 19

# FIG. 20

# FIG. 21

72

| 15 | Detector | | Detector | 16 |
|---|---|---|---|---|

| 18 | Detector I/F Circuit | | Detector I/F Circuit | 19 |
|---|---|---|---|---|

39   21

38   Procesing Unit ← Setting Unit

23   Controller

22

| Louver | Compressor | Fan |
|---|---|---|

40   41   42

# FIG. 22

# FIG. 23

# FIG. 24

83

82 Detector

84 Detector I/F Circuit

21

39

38 Procesing Unit ← Setting Unit

23 Controller

22

Louver | Compressor | Fan

40 | 41 | 42

FIG. 25

# FIG. 26

# FIG. 27

480

403    481(483a)    482

499

Signal Processing Circuit

# FIG. 28A

483a

418
409  414  405a  404  402

28B

28C

418
410

405c

28B

416
412

28C

406
413
405
417
411

418  415  405b

D406

D405

# FIG. 28B

483a

401  416        411        408
                            407b  } 407
                            407a

402
403

# FIG. 28C

483a

401      418      411        408
                              407b } 407
            416               407a

402
403

# FIG. 29A

## FIG. 29B

## FIG. 29C

# FIG. 30A

## FIG. 30B

483c

401   416   411

408
407

402
403

## FIG. 30C

483c

401   418   411

408
407

416

402
403

# FIG. 31A

483d

418 414     404     402

416

31B                                 31B

31C 412                          31C

418

413

405

417                                   411

418 415

D406           D405

## FIG. 31B

483d

416 401 411

408
407

402
403

## FIG. 31C

483d

418 401 411

408
407

416

402
403

FIG. 32A

FIG. 32B

# FIG. 32C

483e

418  401  418  411  418

408
407

412

402
403

414  416  416  414

# FIG. 32D

483e

401  416  418  411

408
407

412  413  417

402
403

# FIG. 33

# FIG. 34

## INTERNATIONAL SEARCH REPORT

| International application No. |
|---|
| PCT/JP2015/005898 |

A. CLASSIFICATION OF SUBJECT MATTER
G01V8/12(2006.01)i, B60H1/00(2006.01)i, B60R16/02(2006.01)i, G01J1/02
(2006.01)i, H01L35/32(2006.01)i

According to International Patent Classification (IPC) or to both national classification and IPC

B. FIELDS SEARCHED

Minimum documentation searched (classification system followed by classification symbols)
G01V8/12, B60H1/00, B60R16/02, G01J1/02, H01L35/32

Documentation searched other than minimum documentation to the extent that such documents are included in the fields searched
Jitsuyo Shinan Koho          1922–1996   Jitsuyo Shinan Toroku Koho   1996–2016
Kokai Jitsuyo Shinan Koho    1971–2016   Toroku Jitsuyo Shinan Koho   1994–2016

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 4-103427 A  (Zexel Corp.),<br>06 April 1992 (06.04.1992),<br>page 3, upper left column, line 9 to page 5,<br>upper left column, line 8<br>(Family: none) | 1,29-30<br>10<br>4-6 |
| X<br>Y<br>A | JP 2005-67460 A  (Denso Corp.),<br>17 March 2005 (17.03.2005),<br>paragraphs [0064], [0065], [0071], [0186]<br>(Family: none) | 1,29-30<br>2-3,7-9<br>4-6 |
| Y<br>A | JP 2005-98886 A  (Calsonic Kansei Corp.),<br>14 April 2005 (14.04.2005),<br>paragraphs [0018] to [0020]<br>(Family: none) | 2-3,7-9<br>4-6 |

☒   Further documents are listed in the continuation of Box C.          ☐   See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>15 February 2016 (15.02.16) | Date of mailing of the international search report<br>23 February 2016 (23.02.16) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

| International application No. |
| --- |
| PCT/JP2015/005898 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y<br>A | JP 63-255116 A  (Diesel Kiki Co., Ltd.),<br>21 October 1988 (21.10.1988),<br>page 3, upper right column, line 15 to page 4,<br>lower right column, line 2<br>(Family: none) | 10<br>4-6 |

Form PCT/ISA/210 (continuation of second sheet) (January 2015)

## INTERNATIONAL SEARCH REPORT

| International application No. |
| --- |
| PCT/JP2015/005898 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
        (See extra sheet.)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.    Consequently, this international search report is restricted to the invention first mentioned in the claims; it is covered by claims Nos.:
        1-10 and 29-30

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (January 2015)

**INTERNATIONAL SEARCH REPORT**

| International application No. |
| --- |
| PCT/JP2015/005898 |

<u>Continuation of Box No.III of continuation of first sheet(2)</u>

Box No. III with respect to unity of invention:
(Document 1) JP 4-103427 A (Zexel Corp.), 06 April 1992 (06.04.1992), page 3, upper left column, line 9 to page 5, upper left column, line 8 (Family: none)
(Invention 1) claims 1-10 and 29-30
Disclosed in Document 1 is "that generally at the center position of the ceiling of a vehicle room is disposed an infrared sensor unit 30 that is provided with a pyroelectric infrared sensor. As illustrated in fig. 3, the infrared sensor unit 30 includes a sensor drive device 31 and a sensor case 33 for accommodating a pyroelectric infrared sensor 32." It is also disclosed in Document 1 that the temperature of the clothes of a passenger is detected to control an air conditioning device and to control the temperature of air blown from a nozzle directed toward a seat in which the passenger is seated. This means that the invention of claims 1, 29, and 30 is disclosed in Document 1. In the light of Document 1, the invention of claims 1, 29, and 30 lacks novelty and thus does not have a special technical feature.
However, the invention of claim 2 has a special technical feature, i.e., "that the detector includes a first detector set up to be closer to the driver's seat than to the front passenger's seat and a second detector set up to be closer to the front passenger's seat than to the driver's seat." The inventions of claims 3-9 are classified into Invention 1 because the inventions also relate to air conditioning control which has the same technical feature and which is based on the detection of a passenger.
The inventions of claim 10 is dependent on claim 1 and has an inventive relationship with claim 1, and is therefore classified into Invention 1.
(Invention 2) claims 11-13 and 31-37
Claims 11-13 and 31-37, which are dependent on claim 1 classified into Invention 1, are classified into Invention 2 because the claims specify an invention of a control interface, such as one for car navigation, which has a special technical feature, i.e., "that the detector has a first detector set up to be closer to the driver's seat than to the front passenger's seat and a second detector set up to be closer to the front passenger's seat than to the driver's seat, and also included is a processing unit which detects the motion of the object being detected in a direction of a plane having a normal that is a straight line connecting between the first detector and the second detector from the output of the first detector and the output of the second detector."
(Invention 3) claims 14-28
Claims 14-28, which are dependent on claim 1 classified into Invention 1, are classified into Invention 3 because the claims specify an invention of an infrared sensor having a special technical feature, i.e.,
"that the infrared sensor is provided with: a substrate having a cavity and a support; a first infrared absorption unit disposed on the cavity; a first beam part disposed on the cavity, connecting between the support and the first infrared absorption unit, and extending in a first direction; and a first connection connecting between the first beam part and the first infrared absorption unit, wherein the first connection extends from the center of the first beam part toward the first infrared absorption unit in a second direction different from the first direction."

Form PCT/ISA/210 (extra sheet) (January 2015)

**REFERENCES CITED IN THE DESCRIPTION**

**Patent documents cited in the description**

- JP 2004067031 A
- JP 2000094923 A
- JP 2006170937 A
- JP 2009288066 A
- JP 2010048803 A